# EUROPEAN PATENT APPLICATION

(11) **EP 3 848 919 A1**
(43) Date of publication of application: **14.07.2021**
(21) Application number: 19856662.2
(22) Date of filing: 23.08.2019
(51) Int. Cl.: G09F 9/33, B60J 1/02, G09F 9/00

(54) **TRANSPARENT DISPLAY DEVICE, GLASS PLATE WITH TRANSPARENT DISPLAY DEVICE, LAMINATED GLASS WITH TRANSPARENT DISPLAY DEVICE, AND MOVING BODY**

(30) Priority: 04.09.2018 JP 2018165127; 22.03.2019 JP 2019054427
(71) Applicant: AGC INC., Chiyoda-ku, Tokyo 1008405 (JP)
(72) Inventor: MORI, Hiroyuki, Tokyo 100-8405 (JP); TAO, Yukihiro, Tokyo 100-8405 (JP)
(74) Representative: Müller-Boré & Partner Patentanwälte PartG mbB
(86) International application number: PCT/JP2019/033035
(87) International publication number: WO 2020/050062

(57) **Abstract**

A transparent display device includes a first transparent substrate (10), light-emitting units arranged on the first transparent substrate (10), and a wiring unit (40) connected to each of the light-emitting units, wherein each of the light-emitting units includes a light-emitting diode having a surface area of 1 mm² or less, and wherein a display region (A) includes a heat dissipation promotion unit (70A) that promotes heat dissipation in the display region.

## Description

### Technical Field

The present invention relates to a transparent display device, a glass plate with a transparent display device, a laminated glass with a transparent display device, and a vehicle.

### Background Art

In the related art, display devices using light-emitting diodes as display pixels are known. Furthermore, a display device of this kind that allows an image on the rear side to be visible through the device is known.

For example, Patent Literature 1 describes a transparent device configured to display information superimposed on a background, provided with a plurality of LED light sources addressable by a conductive pathway deposited on a transparent underlying layer.

Patent Literature 2 describes setting lateral dimensions and an average thickness of electrical interconnections, or heat capacity and heat conductivity of the electrical interconnections to predetermined values in order to suppress the temperature rise of the LEDs in a transparent display device such as Patent Literature 1.

### Citation List

### Patent Literature

Patent Literature 1: Japanese Unexamined Patent Application Publication No. 2006-301650
Patent Literature 2: USP 9,765,934

### Summary of Invention

### Technical Problem

However, there is no description or suggestion in Patent Literature 2 regarding the temperature rise of members other than the LED, and if the members other than the LED generate heat, the temperature of the display region may become high.

In view of the above, in an embodiment of the present invention, it is an object of the present invention to suppress a temperature rise of a display region in a transparent display device.

### Solution to Problem

In order to solve the above problem, an embodiment of the present invention is a transparent display device including a first transparent substrate, light-emitting units disposed on the first transparent substrate, and a wiring unit connected to each of the light-emitting units, wherein each of the light-emitting units includes a light-emitting diode having a surface area of 1 mm² or less, and wherein a display region includes a heat dissipation promotion unit that promotes heat dissipation in the display region.

### Advantageous Effect of Invention

According to an embodiment of the present invention, the temperature rise of the display region can be suppressed in the transparent display device.

### Brief Description of Drawings

Fig. 1 is a schematic diagram illustrating a basic configuration of a transparent display device according to a related art of the present invention in plan view;
Fig. 2 is a cross-sectional view illustrating a part of the transparent display device according to the related art;
Fig. 3 is a schematic diagram illustrating a part of the transparent display device according to the related art in plan view;
Fig. 4 is a schematic diagram illustrating a part of the transparent display device according to another example of the related art in plan view;
Fig. 5 is a schematic diagram illustrating a heat-generating state of the transparent display device according to the related art;
Fig. 6 is a schematic diagram illustrating a transparent display device according to a first embodiment of the present invention in plan view;
Fig. 7 is a cross-sectional view illustrating a part of the transparent display device according to the first embodiment;
Fig. 8A is a schematic diagram illustrating a part of the transparent display device according to the first embodiment in plan view;
Fig. 8B is a cross-sectional view illustrating a part of the transparent display device according to the first embodiment;
Fig. 9 is a schematic diagram illustrating the transparent display device according to a modification example of the first embodiment in plan view;
Fig. 10 is a schematic diagram illustrating the transparent display device according to another modification example of the first embodiment in plan view;
Fig. 11 is a schematic diagram illustrating the transparent display device according to still another modification example of the first embodiment in plan view;
Fig. 12A is a cross-sectional view illustrating a part of the transparent display device according to still another modification example of the first embodiment;
Fig. 12B is a cross-sectional view illustrating a part of the transparent display device according to still another modification example of the first embodiment;
Fig. 12C is a cross-sectional view illustrating a part of the transparent display device according to still another modification example of the first embodiment;
Fig. 13 is a schematic diagram illustrating a transparent display device according to a second embodiment of the present invention in plan view;
Fig. 14 is a cross-sectional view illustrating a part of the transparent display device according to the second embodiment;
Fig. 15 is a schematic diagram illustrating the transparent display device according to a modification example of the second embodiment in plan view;
Fig. 16 is a schematic diagram illustrating the transparent display device according to another modification example of the second embodiment in plan view;
Fig. 17 is a schematic diagram illustrating the transparent display device according to still another modification example of the second embodiment in plan view;
Fig. 18A is a cross-sectional view illustrating a part of the transparent display device according to still another modification example of the second embodiment;
Fig. 18B is a cross-sectional view illustrating a part of the transparent display device according to still another modification example of the second embodiment;
Fig. 19 is a schematic diagram illustrating a transparent display device according to a third embodiment of the present invention in plan view;
Fig. 20 is a cross-sectional view illustrating a part of the transparent display device according to the third embodiment;
Fig. 21 is a schematic diagram illustrating the transparent display device according to a modification example of the third embodiment in plan view;
Fig. 22 is a cross-sectional view illustrating a part of a transparent display device according to a fourth embodiment of the present invention;
Fig. 23 is a cross-sectional view illustrating a part of a transparent display device according to a fifth embodiment of the present invention;
Fig. 24 is a cross-sectional view illustrating a part of a laminated glass according to a sixth embodiment of the present invention;
Fig. 25 is a cross-sectional view illustrating a part of a laminated glass according to a seventh embodiment of the present invention;
Fig. 26 is a cross-sectional view illustrating a part of an automotive according to an eighth embodiment of the present invention; and
Fig. 27 is a schematic diagram of a windshield in the eighth embodiment and a modification example as viewed from an interior of a vehicle.

### Description of Embodiment

The following is a description of embodiments for implementing the present invention. In each drawing, the same or corresponding configurations may be designated by the same or corresponding reference numerals, and explanations may be omitted. The present invention is not limited to the following embodiments.

An embodiment of the present invention is a transparent display device including a first transparent substrate, light-emitting units disposed on the first transparent substrate, and a wiring unit connected to each of the light-emitting units, wherein each of the light-emitting units includes a light-emitting diode having a surface area of 1 mm² or less, and wherein a display region includes a heat dissipation promotion unit that promotes heat dissipation in the display region.

As used herein, the term "transparent display device" means that a display device in which visual information such as a person or a background located on the rear side of the display device (opposite to an observer) is visible under a desired operating environment. "Visible" is determined at least when the display device is non-displayed, that is, not energized.

Also, as used herein, the term "transparent" (or having translucency) means that the transmittance of visible light is 40% or more, preferably 60% or more, and more preferably 70% or more. It may also refer to a transmittance of 5% or more and a haze (cloudiness value) of 10 or less. If the transmittance is 5% or more, sufficient visibility can be ensured because the brightness of the outdoors is the same as or more than that of indoors when looking outdoors from indoors during the daytime. If the transmittance is 40% or more, even if the brightness of the observer side and the other side (rear side) of the transparent display device is the same, the other side of the transparent display device can be seen practically without any problem. If the haze is 10 or less, the contrast of the background can be secured to 10, so that the other side of the transparent display device can be seen practically without any problem. As used herein, the term "transparent" means transparent, regardless of whether or not a color is applied, that is, it includes colorless transparent and colored transparent. The transmittance refers to the value (%) measured by a method conforming to ISO 9050. Haze (cloudiness) refers to the value measured by a method conforming to ISO 14782.

As used herein, the term "display region" means a region in which an image (including characters) is displayed in the transparent display device and is a region including a maximum range in which luminance can be changed by the light-emitting units and a range in which the wiring unit for driving the light-emitting units is arranged. In a case where the driver for driving the light-emitting units is formed of a transparent member and is disposed on the first transparent substrate, the "display region" herein means a region including a maximum range where the luminance can be changed by the light-emitting units and a region where power lines, the wiring unit of signal lines and the driver are disposed.

As used herein, the term "glass plate" includes both inorganic glass and organic glass. For example, the inorganic glass includes soda-lime glass, alkali-free glass, borosilicate glass, and the like, and organic glass includes transparent resins such as polycarbonate or acrylic resin.

### <Related Art>

First, a schematic configuration of the transparent display device of the related art of the present invention will be described.

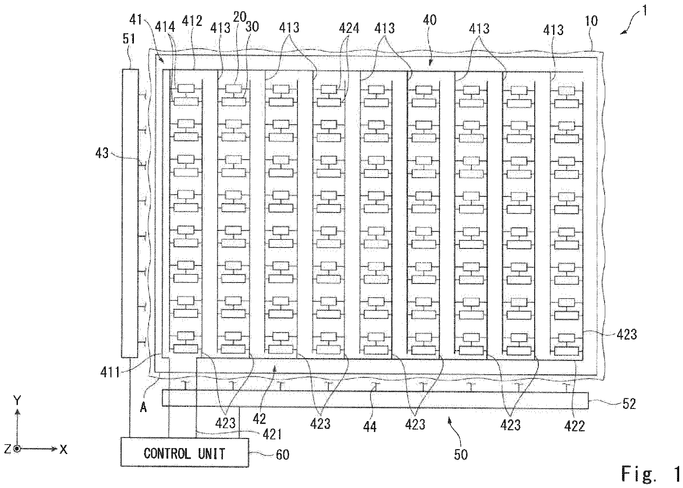

As illustrated in Fig. 1, a transparent display device 1 is provided with a first transparent substrate 10, light-emitting units 20, IC chips 30, a wiring unit 40, a driver 50, and a control unit 60 including an electric circuit board. In this related art and each of the embodiments described below, a display region A of the transparent display device 1 includes the light-emitting units 20 and the IC chips 30 as a whole, and one region of the wiring unit 40 when viewed in plan view. If the driver 50 is made of a transparent material and is adjacent to a region of the first transparent substrate 10, where an image is displayed, the driver 50 may also be included in the display region A.

The light-emitting units 20 are arranged in the display region A in a row direction and a column direction (X-direction and Y-direction in the drawing, respectively), that is, in a matrix (lattice) pattern. However, the arrangement form of the light-emitting units 20 is not limited to a matrix pattern but may also be a staggered grid pattern (offset pattern) or another arrangement form in which light-emitting units of the same color are arranged in a specific direction at substantially constant intervals.

The IC chips 30 are connected to the light-emitting units 20 and drive the light-emitting units 20. Note that the IC chips 30 may be omitted.

The wiring unit 40 has a power line 41, a ground line 42, row data lines 43, and column data lines 44, each of which is a linear strip.

The power line 41 includes a first power main line 411 extending from the control unit 60 in the upward direction (column direction) in Fig. 1, a second power main line 412 extending from an end of the first power main line 411 in the rightward direction (row direction), a plurality of first power branch lines 413 extending from a plurality of locations on the second power main line 412 in the downward direction (column direction) and second power supply branch lines 414 extending in the rightward direction (row direction) respectively from a plurality of locations on the first power main line 411 and the first power branch lines 413 and connected to the light-emitting units 20 and the IC chips 30, respectively.

The ground line 42 includes a first ground main line 421 extending from the control unit 60 in the upward direction (column direction) in Fig. 1, a second ground main line 422 extending from an end of the first ground main line 421 in the rightward (row direction) direction, a plurality of first ground branch lines 423 extending from a plurality of locations on the second ground main line 422 in the upward direction (column direction), and a plurality of second ground branch lines 424 extending from a plurality of locations on the first ground branch lines 423 in the leftward (row direction) direction and connected to the light-emitting units 20 and the IC chips 30, respectively. The second ground main line 422 is not electrically and directly connected to the first power branch lines 413. The first ground branch lines 423 are not electrically and directly connected to the second power main line 412.

In this configuration, a current (electric current) supplied from the control unit 60 flows to each light-emitting unit 20 and each IC chip 30 via the power line 41 and returns to the control unit 60 via the ground line 42.

The row data lines 43 are electrically connected to a row driver 51 and the IC chips 30 lined up in the row direction. The column data lines 44 are electrically connected to a column driver 52 and to the IC chips 30 lined up in the column direction.

The driver 50 controls the driving of the IC chips 30 under the control of the control unit 60. The driver 50 has the row driver 51 which is connected to the IC chips 30 lined up in the column direction and controls driving of the IC chips 30, and the column driver 52 which is connected to the IC chips 30 lined up in the row direction and controls driving of the IC chips 30. At least one of the row driver 51 and the column driver 52 may be made of a transparent material and disposed on the first transparent substrate 10. If the material is not made of a transparent material, it may be disposed at a location other than the first transparent substrate 10.

Next, the detailed configuration of the transparent display device 1 will be described.

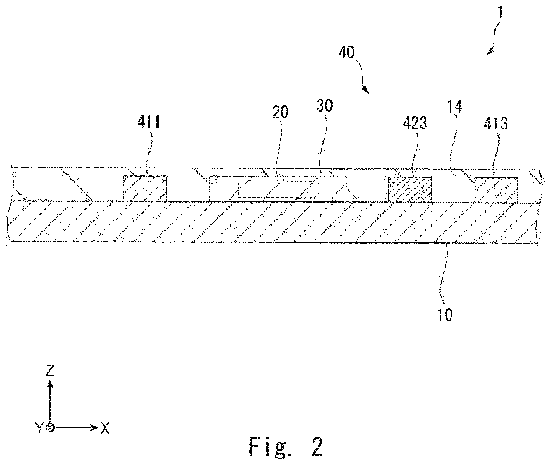

As illustrated in Fig. 2, the light-emitting units 20, the IC chips 30, the wiring unit 40, and an insulation layer 14 insulating these components are disposed on the main surface of the first transparent substrate 10. Examples of the insulation layer 14 include: inorganic layers such as SiOₓ, SiNₓ, AlN, SiAlOₓ or SiON; resin layers such as cycloolefin, polyimide, epoxy, acrylic, or novolac; layers of silicon-based, such as siloxane-based or silazane-based polymer materials; layers of the above materials; and layers of organic and inorganic hybrid material layers.

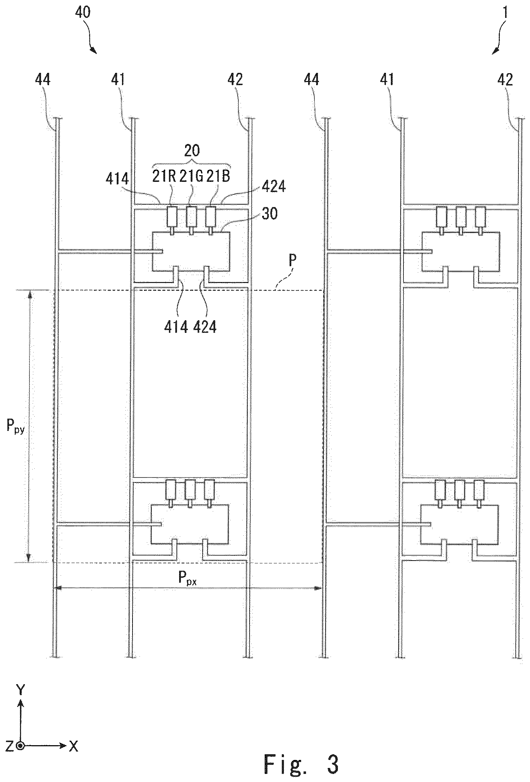

As illustrated in Fig. 3, the light-emitting units 20 are arranged in the row direction and the column direction, that is, in a matrix pattern (lattice pattern). However, the arrangement form of the light-emitting units 20 is not limited to a matrix pattern but may also be a staggered grid pattern (offset pattern) or another arrangement form in which light-emitting units of the same color are arranged in a specific direction at constant intervals.

Each of the plurality of light-emitting units 20 is provided for each pixel (also referred to as a pixel, a display pixel) of the transparent display device 1. In other words, each light-emitting unit 20 corresponds to each pixel of the transparent display device 1, and a single light-emitting units 20 constitutes one pixel. The single light-emitting unit 20 may include a plurality of pixels.

Each light-emitting unit 20 includes at least one light-emitting diode (LED). Therefore, in this embodiment, at least one LED constitutes each pixel of the transparent display device 1. In this manner, the transparent display device 1 in this embodiment is a display device that uses LEDs as pixels and is a so-called LED display (LED display device).

Each light-emitting unit 20 may include two or more LEDs. For example, it may include three LEDs having different wavelengths from each other. More specifically, each light-emitting unit 20 may include a red LED 21R, a green LED 21G, and a blue LED 21B (hereinafter sometimes referred to collectively as LEDs 21). Each LED corresponds to each sub-pixel (sub-pixel) that constitutes one pixel. In this manner, each light-emitting unit 20 has LEDs capable of emitting each of the three primary colors of light (R, G, and B), so that a set of LEDs of the three colors can constitute a single pixel, which can thereby display a full-color image. Two or more LEDs of the same color may be included in each light-emitting unit 20. This increases the dynamic range of the video.

The LEDs used in this embodiment are preferably micro-sized, so-called mini-LEDs, and more preferably, those having a size even smaller than mini-LEDs, so-called micro-LEDs. Specifically, the length of the mini-LEDs in the row direction (X-direction) may be 1 mm or less, and the length in the column direction (Y-direction) may be 1 mm or less. The length of the micro LED in the row direction may be 100 µm or less, preferably 50 µm or less, and more preferably 20 µm or less. The length of the micro LED in the column direction may be 100 µm or less, preferably 50 µm or less, and more preferably 20 µm or less. Although there is no particular limit to the lower limit of the length of the LED in the row direction and column direction, it is preferable from the standpoint of thermal countermeasures to have a size of a certain level or higher because the amount of heat generated rises in inverse proportion to the surface area when the same luminance is obtained in a small surface area. In addition, it is preferable that each of them be 1 µm or more to reduce an edge effect in particular, due to various conditions in manufacturing.

The surface area occupied by one LED on the first transparent substrate 10 may be 1 mm² or less. The surface area is preferably 10,000 µm² or less, more preferably 1,000 µm² or less, and even more preferably 100 µm² or less. The lower limit of the surface area occupied by one LED on the first transparent substrate 10 can be 10 µm² or more due to various conditions in manufacturing and the like.

Normally, it is said that the limit for a person with visual acuity of 1.5 to be able to see the thickness in an image at a distance of 1 m is 50 µm, and it is difficult to see directly when the thickness is 15 µm or less. Therefore, by using a micro-sized LED as described above, the LED is not visible or, even if it is visible, its presence is not noticeable even when an observer observes the display device at a relatively close distance, for example, several tens of centimeters to 2 meters. Therefore, the visibility of the image on the rear side of the display device is improved.

In addition, when a flexible material is used as the first transparent substrate 10, even if the resulting display device is bent, the LEDs can function properly as pixels without being damaged because the micro-sized LEDs are used as described above. Therefore, even when the display device in this embodiment is mounted on a glass plate having a curved surface, for example, a glass plate bent in two directions orthogonal to each other, or when the display device is enclosed between two such glass plates, the display device is hardly damaged.

The transparency of the LED itself is low, for example, its transmittance is about 10% or less. The reason for this is that a mirror structure is formed on the top or bottom surface of the LED in order to efficiently extract the electrodes and light to one side. Therefore, by using micro-sized LEDs, the region where the LEDs prevent light transmission can be reduced, and the region with low transmittance (e.g., the region having a transmittance of 20% or less) in the display region can be reduced. In addition, the use of micro-sized LEDs increases the region of high transmittance in pixels, which improves the transparency of the display device and the visibility of the image on the rear side. In addition, flexibility in configuration of elements other than the light-emitting unit, such as wiring, can be increased while ensuring high transparency of the display device.

There is no limitation on the type of LED used, and it can be a chip type. The LED may be unpackaged, entirely enclosed in a package, or at least partially covered with resin. It is also possible for the covered resin to have a lens function to increase the utilization rate of light and the efficiency of extraction to the outside. In that case, one LED may be enclosed in one package. Alternatively, three LEDs that emit light of different wavelengths from each other can be enclosed in a single package (3-in-1 chip). In addition, it is possible to use a product that emits light at the same wavelength but can extract different types of light by using a phosphor or the like. When the LEDs are packaged, the surface area occupied by one LED and the dimensions of the LED (x-direction and y-direction dimensions) described above refer to the surface area and dimensions in the state after packaging. When three LEDs are enclosed in a single package, the surface area of each LED can be one third or less of the total package surface area.

The shape of the LED is not limited, but may be rectangular, square, hexagonal, pyramidal structure, pillar shape, and the like.

LEDs can be grown by liquid-phase growth, HDVPE, MOCVD, or the like, and the resulting LEDs can be cut and mounted. The LEDs can also be peeled off from the semiconductor wafer and transferred onto a substrate by microtransfer printing or other methods.

The material of the LED is not limited, but it is preferable if it is an inorganic material. For example, for red LEDs, AlGaAs, GaAsP, GaP, and the like are preferable as materials for a light-emitting layer. For green LEDs, InGaN, GaN, AlGaN, GaP, AlGaInP, ZnSe, and the like are preferred. For blue LEDs, InGaN, GaN, AlGaN, ZnSe, and the like are preferred.

The luminous efficacy (energy conversion efficiency) of the LED is preferably 1% or more, more preferably 5% or more, and even more preferably 15% or more. By using LEDs with a luminous efficacy of 1% or more, sufficient luminance can be obtained even if the size of the LED is minute, as described above, and the LEDs can be used as display members during the day. If the luminous efficacy of the LEDs is 15% or more, the amount of heat generation and the like can be reduced, and it is easier to seal the LEDs inside the laminated glass using a resin adhesive layer.

As illustrated in Fig. 3, the light-emitting units 20 are provided at predetermined intervals. The pitch between the light-emitting units 20 corresponds to the pitch of the pixels. In Fig. 2, the pixel pitch in the X-direction is indicated by Pₚₓ, and the pixel pitch in the Y-direction is indicated by P_{py}. When the term "pixel pitch" is used herein, it refers to at least one of the pixel pitch Pₚₓ in the X-direction and the pixel pitch P_{py} in the Y-direction.

Pₚₓ is, for example, 30 mm or less, preferably between 100 µm and 5,000 µm, more preferably between 180 µm and 3,000 µm, and even more preferably between 250 µm and 1,000 µm. The P_{py} is, for example, 30 mm or less, preferably between 100 µm and 5000 µm, more preferably between 180 µm and 3,000 µm, and even more preferably between 250 µm and 1,000 µm. The surface area of one pixel region P is represented by Pₚₓ×P_{py}. The surface area of one pixel is, for example, 900 mm² or less, preferably between 1×10⁴ µm² and 2.5×10⁷ µm², more preferably between 3×10⁴ µm² and 9×10⁶ µm², and even more preferably between 6×10⁴ µm² and 1×10⁶ µm².

By setting the pixel pitch in the above range, high translucency can be achieved while ensuring sufficient display performance. It can also reduce or prevent diffraction phenomena that may be caused by light from the rear side of the transparent display device.

The pixel density in the display region of the display device in this embodiment may be 0.8 ppi or more, preferably 5 ppi or more, more preferably 10 ppi or more, and even more preferably 25 ppi or more.

The above pixel pitch can be equivalent to the pitch of LED of the same color included in each light-emitting unit 20. For example, the pixel pitch Pₚₓ in the X-direction can correspond to the pitch of the red LEDs 21R in the X-direction, and the pixel pitch P_{py} in the Y-direction can correspond to the pitch of the red LEDs 21R in the Y-direction.

The surface area of one pixel can be selected appropriately depending on the size of the screen or display region, application, viewing distance, and the like. By setting the surface area of one pixel to be between 1×10⁴ µm² and 2.5×10⁷ µm², the transparency of the display device can be improved while ensuring appropriate display performance.

The surface area of each LED may be 30% or less, preferably 10% or less, more preferably 5% or less, and further preferably 1% or less, relative to the surface area of one pixel. By reducing the surface area of one LED to 30% or less of the surface area of one pixel, transparency and the visibility of the image on the rear side of the display device can be improved.

The total surface area occupied by the LEDs in the display region may be 30% or less, preferably 10% or less, more preferably 5% or less and further preferably 1% or less.

In Fig. 3, for each pixel, the red LEDs 21R, green LEDs 21G, and blue LEDs 21B are arranged in a row in the X-direction, but the arrangement of the three LEDs is not limited to that illustrated in the figure. For example, the order in which the three LEDs are arranged may be changed, such as by arranging the green LEDs 21G, the blue LEDs 21B, and the red LEDs 21R in this order. The three LEDs may be aligned in the Y-direction by changing their arrangement direction. Alternatively, instead of arranging the three LEDs 21R, 21G, and 21B in a row, each LED may be arranged to be located at the apex of a triangle. A plurality of LEDs of the same color may be installed in a single pixel, and each LED of the same color may be arranged to form a group, or LEDs of different colors may be installed in a configuration such that LEDs of the same color system are simultaneously lit as one color in a single pixel with LEDs of different colors installed alternately. This reduces the amount of heat generation by each LED.

When each light-emitting unit 20 is provided with a plurality of LEDs, the distance between the LEDs in each pixel (in each light-emitting unit 20) is, for example, 3 mm or less. It is preferably 1 mm or less, more preferably 100 µm or less, and further preferably 10 µm or less. In each light-emitting unit 20, the plurality of LEDs may be arranged in contact with each other. This makes it easier to share power supply wiring and improves the aperture ratio.

When each light-emitting unit 20 includes a plurality of LEDs, the arrangement order, arrangement direction, and the like of the plurality of LEDs in each pixel may be the same as, or different from each other. If each light-emitting unit 20 includes three LEDs emitting light of different wavelengths, in some light-emitting units 20, the LEDs may be arranged in a line in the X or Y-direction, and in some another of the light-emitting units 20, the LEDs of each color may be arranged so that they are located at the vertices of the triangle, respectively.

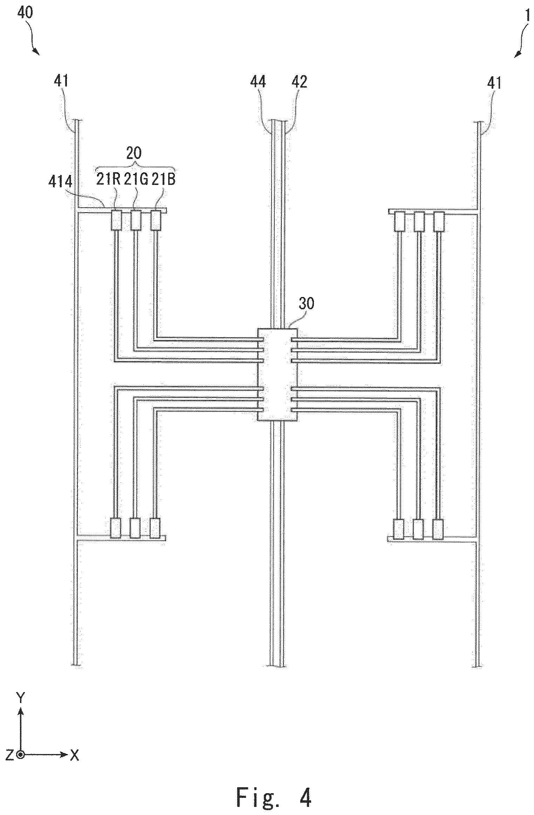

Each IC chip 30 is arranged corresponding to each pixel, that is, for each pixel (for each light-emitting unit 20) and drives each pixel. Each IC chip 30 can also be arranged corresponding to a plurality of pixels, that is, for each plurality of pixels, as illustrated in Fig. 4, to drive the plurality of pixels. In the example of Fig. 4, one IC chip 30 is configured to drive the light-emitting units of four pixels.

Although the IC chips 30 may be arranged on the first transparent substrate 10, a metal pad made of copper, silver, gold, or the like may be disposed on the first transparent substrate 10 and the IC chip may be disposed thereon. The LEDs 21 described above may also be arranged on the pad in a similar manner. The surface area occupied by the pad is preferably between 80 µm² and 40,000 µm², and more preferably between 300 µm² and 2,000 µm².

As the IC chips 30, a hybrid IC or the like provided with an analog portion and a logic portion can be used. The surface area of the IC chips 30 may be 100,000 µm² or less, preferably 10,000 µm² or less, and more preferably 5,000 µm² or less. The analog portion of the IC chip 30 may include a transformer circuit or the like in addition to the circuit for controlling the amount of current. The transparency of the IC chip 30 itself is low, and for example, has a transmittance of about 20% or less. Therefore, by using the IC chips 30 of the above size, the region where the IC chips 30 interferes with the transmission of light may be reduced, which may contribute to a reduction of the region of low transmittance (e.g., the region having a transmittance of 20% or less) in the display region. The use of IC chips 30 having a surface area of 20,000 µm² or less increases the region of high transmittance, thereby improving the transparency of the display device and the visibility of the image on the rear side.

As illustrated in Fig. 4, in a configuration in which one IC chip 30 is arranged for a plurality of pixels, the number of IC chips 30 arranged in the display region A is small, and the total surface area occupied by the IC chips 30 is small. As a result, the transparency of the transparent display device 1 is further improved.

In this embodiment, an LED with an IC chip, in which the LED and the IC chips 30 are packaged together, can also be used. The IC chips 30 may be replaced by a circuit containing a thin-film transistor (TFT).

The wiring unit 40 is connected to each light-emitting unit 20 as described above, and each light-emitting unit 20 may be individually controllable.

The materials of the wiring unit 40 include metals such as copper, aluminum, silver, and gold, carbon nanotubes, and the like, ITO (tin-doped indium oxide (Indium Tin oxide)), ATO (antimony-doped tin oxide (Antimony Tin oxide)), PTO (phosphorus-doped tin oxide (Phosphorus Tin oxide)), ZnO₂, ZSO ((ZnO)_{X}•(SiO₂)_{(1-X)}), and other transparent conductive materials. Of these materials, copper is preferred because of its low resistivity. The wiring unit 40 may be coated with a material such as Ti, Mo, copper oxide, or carbon for the purpose of reducing reflectivity. Unevenness may be formed on the surface of the coated material.

The width of each wire included in the wiring unit 40 is preferably 100 µm or less, more preferably 50 µm or less, and further preferably 15 µm or less. As described above, it is said that the limit for a person with visual acuity of 1.5 to be able to see the thickness in an image at a distance of 1 m is 50 µm, and it is difficult to see directly when the thickness is 15 µm or less. Therefore, by setting the width of the lines to 100 µm or less, preferably 50 µm or less, the wiring unit is not visible or, even if visible, are not noticeable even when the observer observes the display device at a relatively close distance, for example, from a distance between several tens of centimeters and about 2 meters. Therefore, the visibility of the image on the rear side of the display device is improved.

When the transparent display device 1 is irradiated with light from outside, diffuse reflection may occur and, in some cases, diffraction or the like may occur, which may reduce the visibility of the image beyond the transparent display device 1. In particular, when the wiring extends mainly in the X and Y-directions, as in the example illustrated in the figure, a cross-shaped diffraction image extending in the X and Y-directions (referred to as a cross diffraction image) tends to appear. In contrast, reducing the width of each wire reduces or prevents diffraction phenomena that may be caused by light from the rear side of the transparent display device, thereby further improving the visibility of the image on the rear side. From the viewpoint of reducing diffraction, the width of each wire should preferably be 50 µm or less, more preferably 10 µm or less, and even more preferably 5 µm or less. The light from the rear side of the transparent display device described above is light emitted from a light source different from the light-emitting units included in the transparent display device.

It is preferable that the width of each wire included in the wiring unit 40 be 0.5 µm or more. By setting the line width to 0.5 µm or more, an excessive increase in wiring resistance can be prevented, which in turn prevents a voltage drop in the power supply and a decrease in signal strength. At the same time, the heat conductivity is improved, which is desirable.

The electrical resistivity of the wires including the wiring unit 40 is preferably 1.0×10⁻⁶ Ωm or less, and more preferably, 2.0×10⁻⁸ Ωm or less. The heat conductivity of the wire including the wiring unit 40 is preferably between 150 W/(m-K) and 5500 W/(m-K), and more preferably between 350 W/(m-K) and 450 W/(m-K).

In the wiring unit 40, the spacing between adjacent wires (including the spacing between wires having different functions) is, for example, between 5 µm and 50,000 µm, preferably between 10 µm and 3,000 µm, and more preferably between 100 µm and 2,000 µm. In at least one of the X-direction and the Y-direction, the spacing between adjacent wires is, for example, between 5 µm and 50,000 µm, preferably between 10 µm and 3,000 µm, and more preferably between 100 µm and 2,000 µm. The spacing between wires having the same function (for example, the spacing between power lines) is preferably between 150 µm and 5000 µm , and more preferably between 300 µm and 3,000 µm.

Dense lines or regions of dense lines may interfere with the visibility of the image on the rear side. Therefore, such a hindrance to visibility can be reduced by setting the distance between adjacent lines to be 5 µm or more. However, if the width of the wire is as small as 5 µm or less, or if the transparency of the display device can be ensured, the light between the wires may be shielded by a black matrix or the like so that a size between the wires is less than the wavelength of light. Also, by setting the distance between adjacent lines to 3,000 µm or less, the wiring can be configured to ensure sufficient display performance.

Also, by setting the distance between the lines of the wiring unit 40 to 100 µm or more in at least one of the X- and Y-directions, a decrease in visibility due to diffuse reflection, diffraction, or the like can be prevented.

The above-described spacing between adjacent wires shall be the maximum spacing between adjacent wires, for example, when the spacing between wires is not constant, such as when wires are curved or not arranged parallel to each other. In this case, as wiring, it is preferable to focus on wiring that extends over a plurality of pixels.

In the embodiments of Figs. 1, 3, and 4, the wiring unit 40 is configured to include wiring extending mainly in the Y-direction at approximately equal intervals in front view (plan view), but the configuration of the wiring unit 40 is not limited to those illustrated in the figures. For example, in the wiring unit 40, the power line 41 and the ground line 42 can be mesh-like wiring extending over a plurality of pixels in each of the X and Y-directions. This allows the power line to have low resistance and the surface area that can be fabricated to be large. In addition, the number of substantially parallel wires constituting the mesh is preferably three or more to achieve both low resistance and improved transmittance.

The row data lines 43 extending over the plurality of pixels are arranged in the X-direction, and the column data lines 44 are arranged in the Y-direction. Such a configuration is preferable from the viewpoint of an increase in surface area of the panel. The row data lines 43 or the column data lines 44 may not be arranged.

Further, in the wiring unit 40, at least three of the power line 41, the ground line 42, the row data lines 43, and the column data lines 44 can be arranged in stack in the thickness direction. In this case, part of the wiring may be embedded in the first transparent substrate 10 or an insulation layer may be sandwiched between the wires so that the power line 41, the ground line 42, the row data lines 43 and the column data lines 44 do not contact each other.

The surface area occupied by the wiring unit 40 in a region of one pixel may be 30% or less, preferably 10% or less, more preferably 5% or less, and further preferably, 3% or less with respect to the area of one pixel. Also, in the surface area occupied by the wiring unit in the entire display region may be 30% or less of the surface area of the display region, preferably 10% or less, more preferably 5% or less, and further preferably 3% or less.

The translucency of the wiring unit 40, which is an aggregate of linear strips, is relatively low, and its transmittance can be, for example, less than 20% or less than 10%. Therefore, by making the region occupied by the wiring unit 30% or less in the region of one pixel and by making the surface area occupied by the wiring unit 30% or less in the display region, the region in which the wiring unit 40 interferes with the transmission of light can be reduced. Therefore, the region with low transmittance (e.g., the region with transmittance of 20% or less) can be reduced in the display region. In addition, by setting the surface area occupied by the wiring unit 40 to 20% or less in the display region, the region of high transmittance is increased, thereby improving the transparency of the display device and improving the visibility of the image on the rear side.

Further, the surface area occupied by the light-emitting units 20, the IC chips 30 and the wiring unit 40 in each pixel (in the region of one pixel) is preferably 30% or less, more preferably 20% or less, and further preferably 10% or less, relative to the surface area of one pixel. The surface area occupied by the light-emitting units 20, the IC chips 30 and the wiring unit 40 is preferably 30% or less, more preferably 20% or less, and further preferably 10% or less with respect to the surface area of the display region A. When the transparent display device 1 is not provided with the IC chips 30, the surface area occupied by the light-emitting units 20 and the wiring unit 40 relative to the surface area of one pixel or the display region A is preferably the same as that when the IC chips 30 are provided.

Furthermore, in this embodiment, the region of low transmittance may be unevenly distributed in a region of one pixel. For example, in a region of one pixel, the wires of the wiring unit 40 may be placed in close proximity to each other, and the light-emitting units 20 and the IC chips 30 may be placed in close proximity to the wiring unit 40. This allows the formation of a high transmittance region with a constant spread in the X- and Y-directions. For example, it is possible to avoid including a low transmittance region, for example, a region with a transmittance of 20% or less, within the region of one pixel. By unevenly distributing the region of low transmittance in the region of one pixel, diffraction of light from the rear side can be further suppressed.

The first transparent substrate 10 is not particularly limited as long as it has insulating properties and is transparent, but preferably includes a resin and mainly including a resin. Examples of resins used for transparent substrates include: polyester resins such as polyethylene terephthalate (PET) and polyethylene naphthalate (PEN); olefin resins such as cycloolefin polymers (COP) and cycloolefin copolymers (COC); cellulose resins such as cellulose, acetyl cellulose, triacetyl cellulose (TAC); imide resins such as polyimides (PI); vinyl resins such as polyethylene (PE), polyvinyl chloride (PVC), polystyrene (PS), polyvinyl acetate (PVAc), polyvinyl alcohol (PVA), polyvinyl butyral (PVB); acrylic resins such as polymethyl methacrylate (PMMA), ethylene vinyl acetate copolymer resin (EVA) or those in which cross-linking has been performed on their backbone, urethane resins, and the like. Thin glass, such as glass of 200 µm or less, preferably 100 µm or less, can also be used as the first transparent substrate 10.

Of the materials used for the above transparent substrate, polyethylene naphthalate (PEN) and polyimides (PI) are preferable from the viewpoint of improving heat resistance. Cycloolefin polymers (COP), cycloolefin copolymers (COC), polyvinyl butyral (PVB), and the like are preferred in that they have low birefringence and can reduce distortion and blurring of images viewed through transparent substrates.

The above materials can be used alone or in combination of two or more, that is, in the form of a mixture of different materials or by layering planar substrates made of different materials. The thickness of the entire first transparent substrate 10 is preferably between 3 µm and 1000 µm, and more preferably between 5 µm and 200 µm. The internal transmittance of visible light of the first transparent substrate 10 is preferably 50% or more, more preferably 70% or more, and further preferably 90% or more.

The first transparent substrate 10 preferably has flexibility. This allows, for example, when the transparent display device 1 is mounted on a curved glass plate or used between two curved glass plates, the transparent display device 1 can easily follow the curvature of the glass plate. It is more preferable if the material shows shrinkage behavior when heated to 100°C or higher.

The first transparent substrate 10 is preferably provided with a passivation layer. A passivation layer is an inorganic layers such as SiOₓ, SiNₓ, AlN, SiAlOₓ, and SiON; a cycloolefin-based, polyimide-based, epoxy-based, acrylic-based, and novolac-based resin layer; a laminate of an inorganic layer and a resin layer; a silicon-based, such as siloxane-based, and silazane-based polymer; or a layer made of hybrid material of organic and inorganic materials.

### <First Embodiment>

In the transparent display device 1 of the above related art, assuming that the amount of current flowing to each light-emitting unit 20 and each IC chip 30 is almost the same, the current flowing in the power line 41 decreases as it moves away from the connection point with the control unit 60. Specifically, the current flowing in the first power main line 411 decreases as it moves upward because a plurality of second power supply branch lines 414 branch off from the first power main line 411. The current flowing in the second power main line 412 decreases as it moves in the rightward direction (away from the first power main line 411) because a plurality of first power branch lines 413 branch off from the second power main line 412. The current flowing in the first power branch lines 413 decreases as it moves downward (as it moves away from the second power main line 412) because a plurality of second power supply branch lines 414 branch off from each of the first power branch lines 413.

On the other hand, the current flowing in the ground line 42 increases as it approaches the connection point with the control unit 60. Specifically, the current flowing in the first ground branch lines 423 increases as it moves downward because a plurality of second ground branch lines 424 are connected to the first ground branch lines 423. The current flowing in the second ground main line 422 increases as it moves in the rightward direction (closer to the first ground main line 421) because a plurality of first ground branch lines 423 are connected to the second ground main line 422.

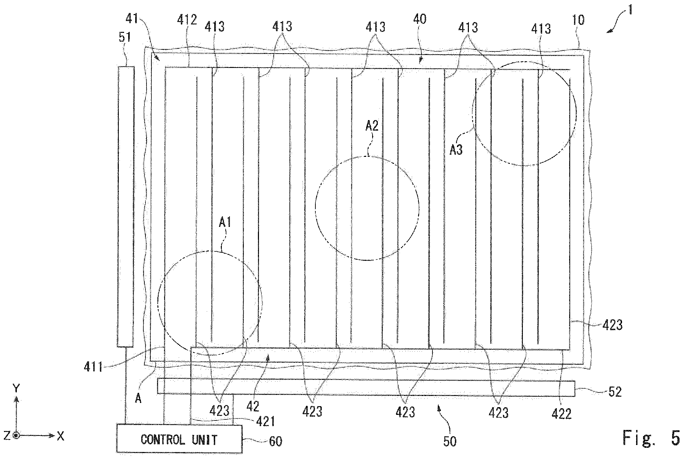

When a current flows through the power line 41 and the ground line 42, the power line 41 and the ground line 42 generate heat. As described above, the magnitude of the current flowing in each region of the power line 41 and ground line 42 is different. Therefore, as illustrated in Fig. 5, when comparing the amount of heat generated in each of a first partial region A1, which is located at the lower left of the display region A and includes a region where the largest amount of current flows in the power line 41 and the ground line 42, a second partial region A2, which is located at the diagonal of the first partial region A1 in the display region A, and a third partial region A3, which is located between the first partial region A1 and the second partial region A2, the largest amount of heat is generated in the first partial region A1, the smallest amount of heat is generated in the second partial region A2, and the amount between those in the first partial region A1 and the second partial region A2 is generated in the third partial region A3.

Since a current also flows through the light-emitting units 20 and the IC chips 30, the light-emitting units 20 and the IC chips 30 also generate heat. However, if the spacing of the pixels is almost the same, the relationship between the amounts of heat generated in the first, second and third partial regions A1, A2 and A3 becomes the same as the relationship described above, even if the heat generated by the light-emitting units 20 and the IC chips 30 in question is taken into account.

Since a current also flows through the row driver 51 and the column driver 52, the row driver 51 and the column driver 52 also generate heat. If the row driver 51 and the column driver 52 are made of transparent materials and are provided on the first transparent substrate 10 at a position adjacent to, for example, the first power main line 411 and the second ground main line 422, the drivers 51 and 52 are also considered to constitute the display region A, and the temperature of the display region A may increase due to the effects of heat generation of the respective drivers 51 and 52.

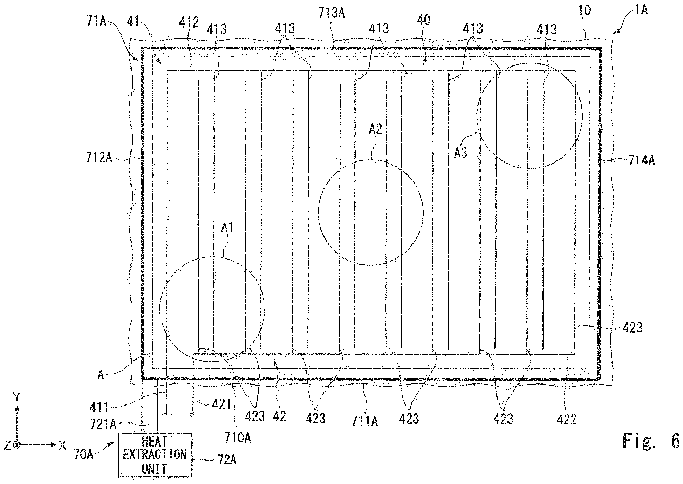

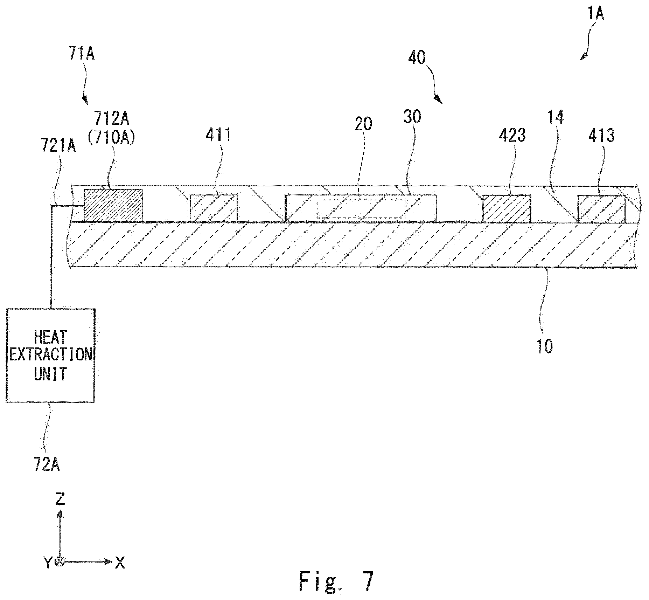

A transparent display device 1A of the first embodiment illustrated in Figs. 6 and 7 has a function of suppressing a temperature rise of the display region A as described above and is provided with a first transparent substrate 10, the light-emitting units 20, the IC chips 30, the wiring unit 40, the driver 50, the control unit 60, and a heat dissipation promotion unit 70A. Since the first transparent substrate 10, the light-emitting units 20, the IC chips 30, and the driver 50 have the same structure as the transparent display device 1, illustration thereof is omitted in Fig. 6. Since the row data lines 43 and the column data lines 44 also have the same structure as that of the transparent display device 1, illustration thereof is omitted.

The heat dissipation promotion unit 70A has a function of promoting heat dissipation of the display region A and is provided with a heat transfer unit 71A and a heat extraction unit 72A.

The heat transfer unit 71A is structurally separate from the wiring unit 40. In this manner, by configuring the heat transfer unit 71A separately from the wiring unit 40, heat dissipation of the display region A can be promoted without making design changes to the light-emitting units 20, the IC chips 30, the wiring unit 40, and so forth.

The heat transfer unit 71A is provided on the first main surface on which the wiring unit 40 is provided in the first transparent substrate 10. The heat transfer unit 71A is formed in the shape of a square frame surrounding the display region A by four heat transfer lines 710A. In this manner, by configuring the heat transfer unit 71A with the heat transfer lines 710A, the decrease in the transmittance of the display region A can be minimized.

The heat transfer lines 710A may be formed of a metal or a carbon-based material such as graphite, graphene, carbide, carbon nanotubes, or diamond. In this manner, by forming the heat transfer lines 710A having high heat conductivity, heat can be transferred quickly.

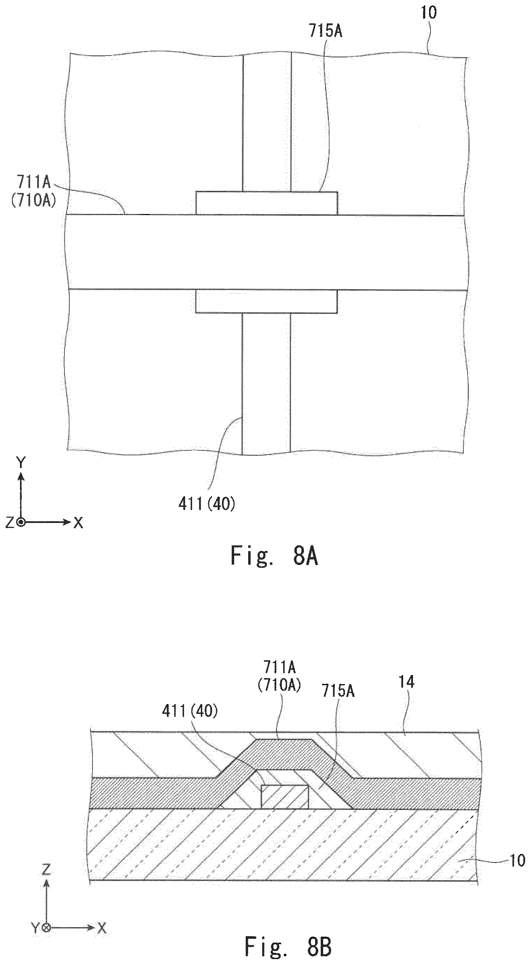

The metallic materials include copper, aluminum, silver, iron, and tungsten carbide. If a carbon-based material other than diamond is used, it is preferable to mix it with a metal or a material that ionizes when added to an electrolyte. This is to increase the heat conductivity and to efficiently transfer heat to other materials at the point where they are connected. When the heat transfer lines 710A are conductive, as illustrated in Figs. 8A and 8B, at the intersection of each of the heat transfer lines 710A and the wiring unit 40, it is preferable to provide an insulation unit 715A therebetween. Examples of the material of the insulation unit 715A include an inorganic material such as silicon oxide or silicon nitride, or an organic photoresist material. The material is preferably made of a material with high heat conductivity, such as aluminum nitride or boron nitride. This is because heat can be transferred from the heat generating parts to the heat transfer lines 710A more efficiently. By providing the insulation unit 715A, even when the conductive heat transfer lines 710A are used, the flexibility in arrangement of the heat transfer lines 710A can be increased.

The heat transfer lines 710A may be formed of an insulating ceramic. Such ceramic materials include aluminum nitride, aluminum oxide, silica, silicon carbide, silicon nitride, and boron nitride. The heat transfer lines 710A made of ceramics may or may not be transparent. In the case where the heat transfer lines 710A are made of ceramics, at the intersection of the heat transfer lines 710A and the wiring unit 40, it is no longer necessary to provide the insulation unit 715A therebetween, thereby increasing the flexibility in arrangement of the heat transfer lines 710A.

The width of the heat transfer lines 710A is preferably between 1 µm and 1000 µm, more preferably between 2 µm and 500 µm. and further preferably between 3 µm and 200 µm. The thickness of the heat transfer lines 710A is preferably between 0.1 µm and 10 µm, more preferably between 0.2 µm and 8 µm, and further preferably between 0.5 µm and 5 µm.

The cross-sectional area of the heat transfer lines 710A may be the same throughout or may be different in one region. To differentiate the cross-sectional area of one region from that of other regions, it is preferable to make the cross-sectional area of the region located in the vicinity of the first partial region A1 larger than that of the region located in the vicinity of the second partial region A2, so that the heat dissipation capability of the region in the vicinity of the first partial region A1 is higher than that of the region in the vicinity of the second partial region A2. In this way, the heat dissipation of the first partial region A1, which generates a large amount of heat and tends to become hot, can be promoted more than that of the second partial region A2. As a result, the uniformity of the temperature distribution in the display region A is enhanced and the unevenness of the light-emitting units 20 can be suppressed. It is preferable to make the cross-sectional area of the region close to a connection unit 721A described later in the heat transfer lines 710A larger than the cross-sectional area of a distant region, so that the heat dissipation capability of the close region is higher than that of the distant region. In this configuration, the amount of heat transferred from the heat transfer lines 710A to the connection unit 721A per unit time can be increased, and the heat dissipation of the first partial region A1 can be further promoted.

Examples of the method of differentiating the cross-sectional area of one region of the heat transfer lines 710A from other regions include differentiating at least one of the width and the thickness. Examples of the method of differentiating at least one of the width and the thickness include linearly increasing or decreasing the width and the thickness or increasing or decreasing the thickness in stages.

The heat extraction unit 72A is connected to the heat transfer lines 710A via the connection unit 721A and removes heat from the heat transfer lines 710A. Examples of the heat extraction unit 72A include a heat-dissipating fin, a heat pipe, a Peltier element, a body of a vehicle such as an automotive (the main body part of the vehicle). The connection unit 721A preferably has a function of efficiently transferring a large amount of heat to the heat extraction unit 72A. From this viewpoint, examples of the materials of the connection unit 721A include: metal materials such as copper, aluminum, silver, iron, and tungsten oxide; ceramic materials such as aluminum nitride, aluminum oxide, silica, silicon carbide, nitrogen silicon, and boron nitride; or dispersions of these materials, as well as carbon-based materials such as graphite, graphene, carbide, carbon nanotubes, or diamond. If a carbon-based material other than diamond is used, it can be mixed with a metal or a material that ionizes when added to an electrolyte, as in the case of the heat transfer lines 710A.

The width of the connection unit 721A is preferably between 1 µm and 10 mm, more preferably between 10 µm and 5 mm, and further preferably between 20 µm and 3 mm. The thickness of the connection unit 721A is preferably between 0.5 µm and 1 mm, more preferably between 2 µm and 500 µm, and further preferably between 5 µm and 300 µm.

The surface area of the display region A of the transparent display device 1A is, for example, between 1×104 mm² and 2×10⁶ mm² and may be between 3×10⁴ mm² and 1×10⁶ mm². Between 1% and 90% of the surface area of the front surface of the transparent display device 1A may be the display region A, and between 5% and 75% of the same may be the display region A. The shape of the display region A may be a rectangle, a square, a shape that is substantially similar to the outline of the transparent display device 1A, or a shape that is longer in the horizontal direction than in the vertical direction relative to the similar shape of the outline of the transparent display device 1A. And the transparent display device 1A can be suitably used in applications where the viewing distance (distance from the observer to the display screen) is relatively short, for example, where the viewing distance is between 0.2 m and 3.0 m. Even in such applications where the viewing distance is relatively short, the use of micro-sized LEDs and a predetermined percentage of low transmittance regions improve transparency and also improve the visibility of the image seen through the display device.

The transparent display device 1A can be manufactured by preparing the first transparent substrate 10, forming the wiring unit 40 and the heat transfer lines 710A on the first transparent substrate 10, and arranging the light-emitting units 20. When manufacturing the transparent display device 1A provided with the IC chips 30, the IC chips 30 can also be placed at the same time in the process of placing the light-emitting units 20 (LEDs 21). Known mounting techniques may be applied to the formation of the wiring unit 40, the arrangement of the light-emitting units 20, and the arrangement of the IC chips 30. For example, a method using solder balls, transfer printing, and the like can be used.

According to the first embodiment described above, when a current flows in the power line 41 and the ground line 42 to display an image and the display region A generates heat due to this current, this heat is transferred to the heat transfer lines 710A and the heat dissipation of the display region A is promoted. Accordingly, even when components other than the light-emitting units 20, for example, the power line 41 and the ground line 42, generate heat, the temperature rise of the display region A is suppressed.

There is no need to change the design of the wiring unit 40 in order to obtain the effect of promoting heat dissipation in the display region A.

When the driver 50 is disposed on the first transparent substrate 10, heat generated by driving the driver 50 is also transferred to the heat transfer lines 710A, thereby promoting heat dissipation of the driver 50, which is a member other than the light-emitting units 20.

By providing a heat extraction unit 72A that removes heat from the heat transfer lines 710A, the heat dissipation efficiency of the display region A can be increased.

### <Modification Example of First Embodiment>

The following embodiment is a modification example of the first embodiment.

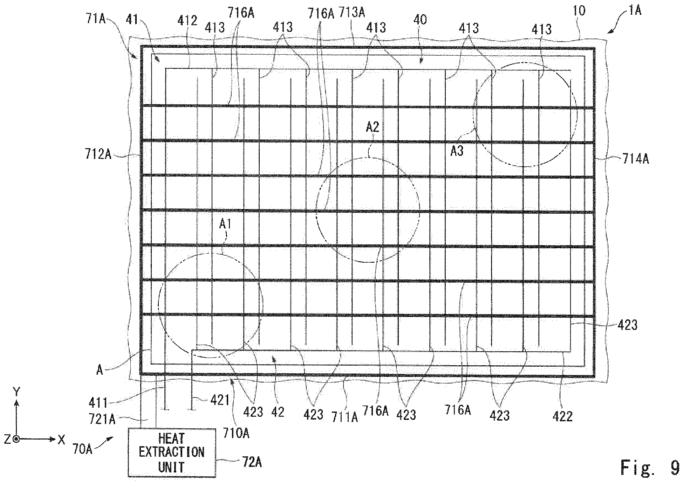

As illustrated in Fig. 9, a plurality of heat transfer lines 716A extending in the row direction may be arranged at predetermined intervals in the column direction in addition to the square framed heat transfer lines 710A of Fig. 6.

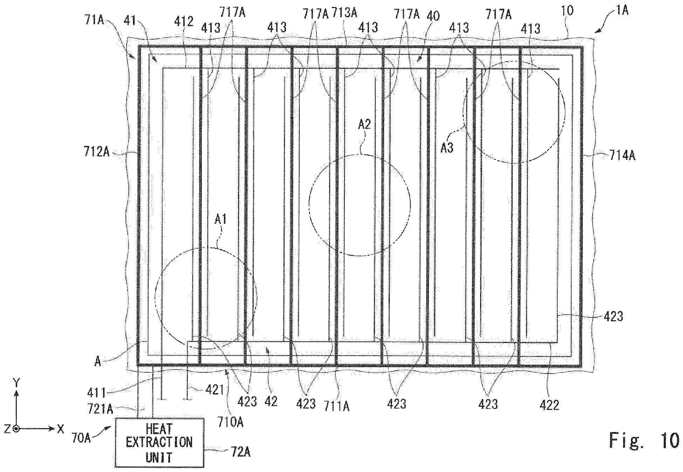

As illustrated in Fig. 10, a plurality of heat transfer lines 717A extending in the column direction may be arranged at predetermined intervals in the row direction in addition to the square framed heat transfer lines 710A of Fig. 6. In this case, the heat transfer lines 717A may or may not overlap with the light-emitting units 20, the IC chips 30, and the first power main line 411, the first power branch lines 413, the first ground main line 421, and the first ground branch lines 423 extending in the column direction.

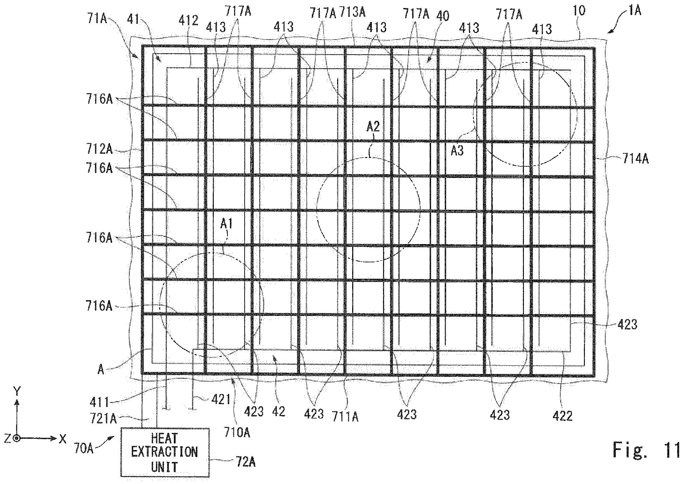

As illustrated in Fig. 11, in addition to the square framed heat transfer lines 710A of Fig. 6, a plurality of heat transfer lines 716A extending in the row direction may be arranged at predetermined intervals in the column direction, and a plurality of heat transfer lines 717A extending in the column direction may be arranged at predetermined intervals in the row direction.

In the configurations of Figs. 9 and 11, the heat transfer lines 716A may or may not overlap with the light-emitting units 20 and the IC chips 30.

In the configuration illustrated in Fig. 10 and Fig. 11, the heat transfer lines 717A may or may not overlap with the light-emitting units 20, the IC chips 30, and the first power main line 411, the first power branch lines 413, the first ground main line 421, and the first ground branch lines 423 extending in the column direction. The heat transfer lines 717A may overlap with at least one of the first power main line 411, the first power branch lines 413, the first ground main line 421, and the first ground branch lines 423 extending in the column direction throughout its length direction. In a case where the heat transfer lines 716A, 717A overlap with at least one of the light-emitting units 20, the IC chips 30, and the first power main line 411, the first power branch lines 413, the first ground main line 421, and the first ground branch lines 423 extending in the column direction, when the heat transfer lines 716A, 717A are made of metal, it is preferable to insert an insulation unit between them, and when the heat transfer lines 716A, 717A are made of ceramics, there is no need to insert the insulation unit between them.

Of the heat transfer lines 710A illustrated in Figs. 6 to 11, only the first heat transfer line 711A on the lower side of the display region A and the second heat transfer line 712A on the left side are provided, and the third heat transfer line 713A on the upper side and the fourth heat transfer line 714A on the right side need not to be provided. In this configuration, the amount of material used for the heat transfer lines 710A can be reduced while promoting heat dissipation in the first partial region A1 located at the intersection of the first and second heat transfer lines 711A, 712A.

In the configurations of Figs. 9 to 11, both ends of the heat transfer lines 716A, 717A are connected to the heat transfer lines 710A, but one or both ends need not be connected to the heat transfer lines 710A. In the configuration of Figs. 9 to 11, the number of heat transfer lines 716A, 717A is not limited to the number shown.

In the configuration of Figs. 9 to 11, the cross-sectional area of the region located in the vicinity of the first partial region A1 in the heat transfer lines 716A, 717A may be made larger than the cross-sectional area of the region located in the vicinity of the second partial region A2 to promote heat dissipation in the first partial region A1 more than in the second partial region A2.

In the configuration of Figs. 6 to 11, the heat extraction unit 72A may not be provided. In this configuration as well, heat is transferred to the heat transfer lines 710A and the heat dissipation of the display region A is promoted. If the plurality of heat extraction units 72A are connected to a plurality of locations of the heat transfer lines 710A via the plurality of connection units 721A, heat dissipation in the display region A can be further promoted.

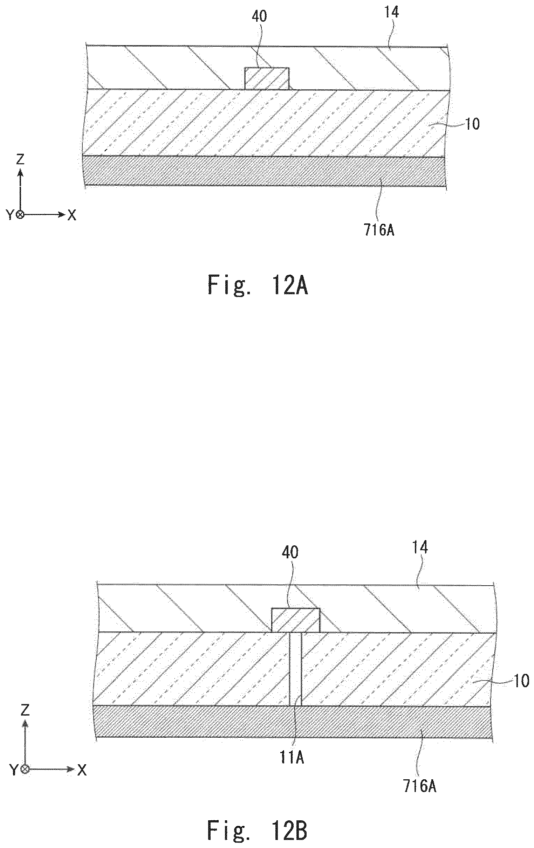

For example, in the configuration of Fig. 9, the heat transfer lines 716A are provided on the same first main surface as the wiring unit 40 in the first transparent substrate 10, but as illustrated in Fig. 12A, the heat transfer lines 716A may be provided on the second main surface of the first transparent substrate 10. In this configuration, without changing the arrangement of the light-emitting units 20, the IC chips 30, the wiring unit 40, and the like on the first transparent substrate 10, the heat of the power line 41 and the ground line 42 is transferred to the heat transfer lines 716A through the first transparent substrate 10 to promote heat dissipation in the display region A.

In order to make it easier to transmit the heat of the power line 41 or the like to the heat transfer lines 716A, it is preferable that the power line 41 and the heat transfer lines 716A overlap in plan view, but even if they do not overlap at all, the effect of transmitting the heat of the power line 41 or the like to the heat transfer lines 716A through the first transparent substrate 10 can be obtained.

As illustrated in Fig. 12B, in the configuration of Fig. 12A, a circular through hole 11A in plan view that penetrates through the thickness direction of the first transparent substrate 10 may be provided, and the wiring unit 40 and the heat transfer line 716A may be arranged to block the respective openings. The diameter of the through hole 11A is preferably between 5 µm and 100 µm, more preferably between 10 µm and 80 µm, and further preferably between 20 µm and 50 µm. In this configuration, the heat of the power line 41 or the like advances in the thickness direction of the first transparent substrate 10 through the through hole 11A and is easily transmitted to the heat transfer line 716A.

The shape of the through hole 11A in plan view may be a polygon such as a triangle or a square, or an oval.

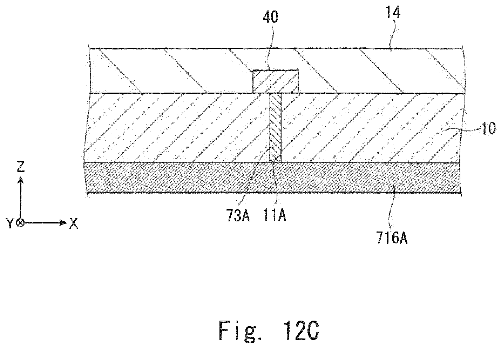

As illustrated in Fig. 12C, in the configuration of Fig. 12B, the through hole 11A may be filled with a heat transfer material 73A that transfers heat of the wiring unit 40 to the heat transfer line 716A. The heat transfer material 73A is preferably made of a material having a high heat conductivity, and such a material includes: a metal material such as copper or aluminum; a ceramic material such as aluminum nitride, aluminum oxide, silica, silicon carbide, silicon nitride, or boron nitride, and also carbon-based materials such as graphite, graphene, a carbide, carbon nanotubes, or diamond. If a carbon-based material other than diamond is used, it can be mixed with a metal or a material that ionizes when added to an electrolyte, as in the case of the heat transfer lines 710A. In this configuration, the heat of the power line 41 and the like is easily transferred to the heat transfer lines 716A via the heat transfer material 73A.

The configuration of Figs. 12A, 12B, and 12C may also be applied to the configurations of Figs. 6, 10, and 11.

The number, shape, and position of the heat transfer lines are not limited to the above-described manner, and any manner may be used as long as the heat dissipation of the display region A can be promoted.

The heat transfer lines 710A, 716A, 717A may be provided on both main surfaces of the first transparent substrate 10, in which case the same or different heat transfer lines may be provided on both main surfaces.

### <Second Embodiment>

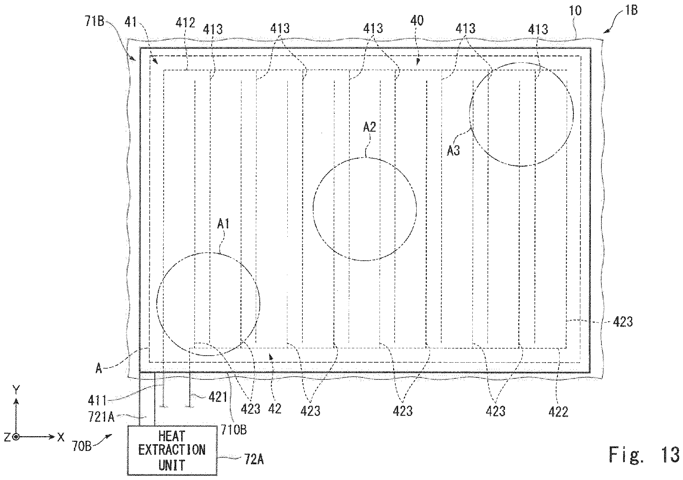

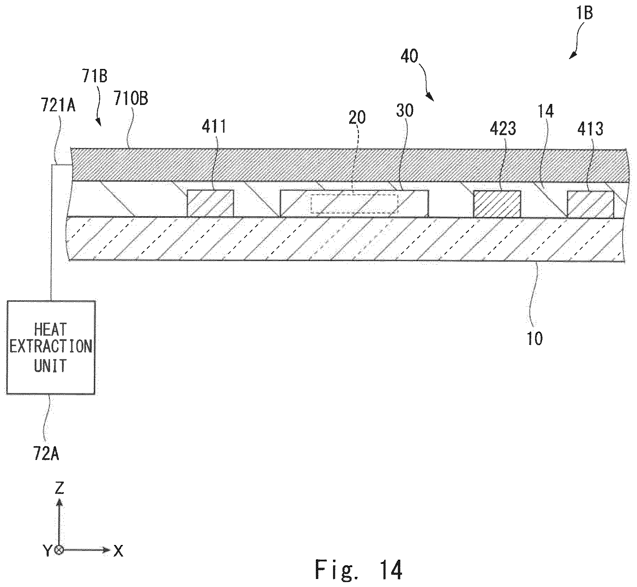

A transparent display device 1B of the second embodiment illustrated in Figs. 13 and 14 has a function of suppressing a temperature rise of the display region A. The difference between the transparent display device 1B of the second embodiment and the transparent display device 1A of the first embodiment is that a heat dissipation promotion unit 70B is provided instead of the heat dissipation promotion unit 70A.

The heat dissipation promotion unit 70B has a heat transfer unit 71B and the heat extraction unit 72A.

The heat transfer unit 71B is structurally separate from the wiring unit 40. In this manner, by configuring the heat transfer unit 71B separately from the wiring unit 40, heat dissipation of the display region A can be promoted without making design changes to the light-emitting units 20, the IC chips 30, the wiring unit 40, and so forth. The heat transfer unit 71B has a rectangular-shaped transparent heat transfer layer 710B. The heat transfer layer 710B is provided on the same first main surface as the wiring unit 40 is in the first transparent substrate 10 so as to cover the entire display region A from above the insulation layer 14. The thickness of the heat transfer layer 710B may be the same throughout or may be different in one region. To differentiate the thickness of one region from that of other regions, it is preferable to make the thickness of the region located in the vicinity of the first partial region A1 thicker than that of the region located in the vicinity of the second partial region A2. In this way, the heat dissipation of the first partial region A1, which generates a large amount of heat and tends to become hot, can be promoted more than that of the second partial region A2. The heat transfer layer 710B is connected to the heat extraction unit 72A via the connection unit 721A.

The heat transfer layer 710B is preferably a layer including a transparent conducting oxide (TCO), and examples of the heat transfer layer 710B include a transparent conductive film such as ITO (tin-doped indium oxide (Indium Tin oxide)), ATO (antimony-doped tin oxide (Antimony Tin Oxide)), PTO (phosphorus-doped tin oxide (Phosphorus Tin oxide)), or ZnO₂, ZSO ((ZnO)_{X}•(SiO₂)_{(1-X)}); a layer including a dispersion of carbon materials such as carbon, carbon nanotubes, graphene, carbide, or diamond; a layer including a dispersion of ceramic particles such as aluminum nitride, aluminum oxide, silica, silicon carbide, silicon nitride, or boron nitride; and a layer including a layer including a metal nanowire such as silver. If a carbon-based material other than diamond is used, it can be mixed with a metal or a material that ionizes when added to an electrolyte, as in the case of the heat transfer lines 710A. When the heat transfer layer 710B is conductive, it is preferable to provide an insulation layer between the heat transfer layer 710B and the light-emitting units 20, the IC chips 30, and the wiring unit 40.

The total light transmittance of the heat transfer layer 710B is preferably 40% or more, more preferably 50% or more, and further preferably 60% or more. The thickness of the heat transfer layer 710B is preferably between 0.1 µm and 1000 µm, more preferably between 0.5 µm and 500 µm, and further preferably between 1 µm and 100 µm.

According to the second embodiment described above, when the display region A generates heat due to the current flowing in the power line 41 and the ground line 42 in conjunction with image display, this heat is transferred to the surface direction of the display region A by the heat transfer layer 710B and the heat dissipation is promoted. Accordingly, even when components other than the light-emitting units 20 generate heat, the temperature rise of the display region A is suppressed.

### <Modification Example of Second Embodiment>

The following embodiment is a modification example of the second embodiment.

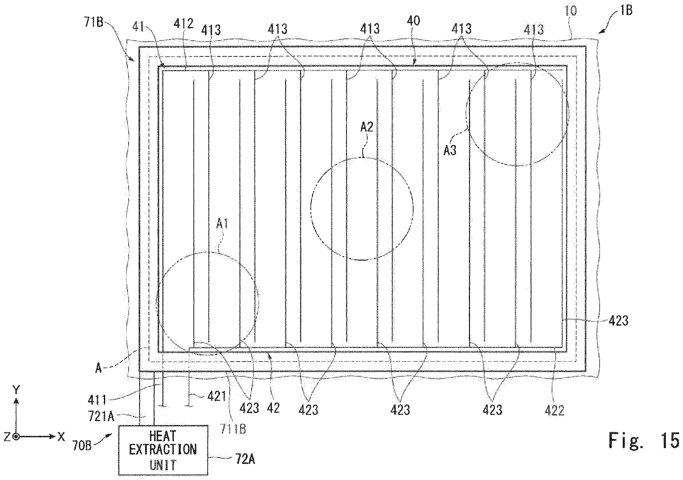

As illustrated in Fig. 15, a square frame-shaped transparent heat transfer layer 711B may be provided on the first main surface of the first transparent substrate 10. The heat transfer layer 711B may be provided so as not to cover all of the light-emitting units 20 and the IC chips 30, or it may be provided so as to cover some of the light-emitting units 20 and the IC chips 30.

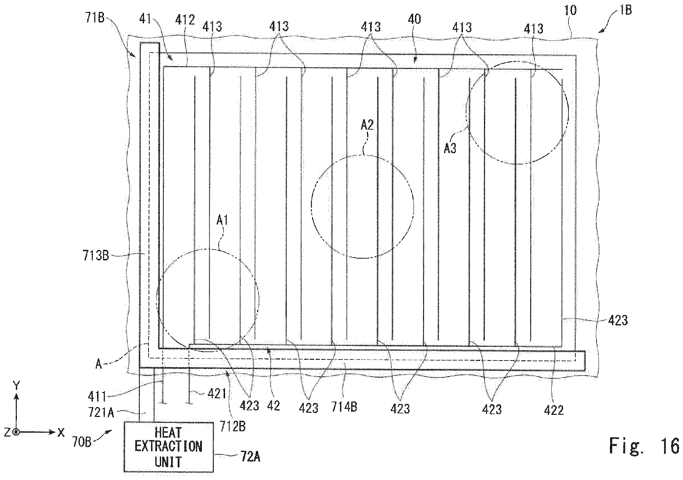

As illustrated in Fig. 16, a heat transfer layer 712B having a first band-shaped part 713B extending in the same direction as the first power main line 411 at a position overlapping with or in proximity to the first power main line 411 and a second band-shaped part 714B extending in the same direction as the second ground main line 422 at a position overlapping with or in proximity to the second ground main line 422, may be provided on the first main surface of the first transparent substrate 10. A connecting part between the first band-shaped part 713B and the second band-shaped part 714B is preferably located in the vicinity of the first partial region A1 from the viewpoint of promoting heat dissipation of the first partial region A1 that generates the largest amount of heat. In this configuration, the amount of material used for the heat transfer layer 712B can be reduced while promoting heat dissipation in the first partial region A1 located at the intersection of the first and second band-shaped parts 713B, 714B.

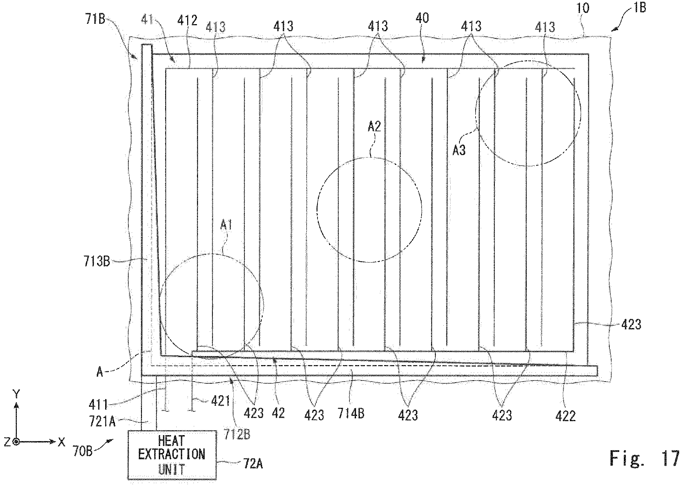

The widths of the first band-shaped part 713B and the second band-shaped part 714B may be constant in the longitudinal direction, as illustrated in Fig. 16, or may become wider or narrower continuously or in stages as they approach the heat extraction unit 72A. The thicknesses of the first band-shaped part 713B and the second band-shaped part 714B may be constant in the longitudinal direction or may become thicker or thinner continuously or in stages as they approach the heat extraction unit 72A. From the viewpoint of increasing the efficiency of heat transfer to the heat extraction unit 72A, the width of the first band-shaped part 713B and the second band-shaped part 714B is preferably wider as it approaches the heat extraction unit 72A, and the thickness is preferably thicker as it approaches the heat extraction unit 72A, as illustrated in Fig. 17.

In the configurations of Figs. 13 to 17, the heat transfer layers 710B, 711B, and 712B may be provided on the second main surface of the first transparent substrate 10, as in the configurations of Figs. 12A, 12B, and 12C.

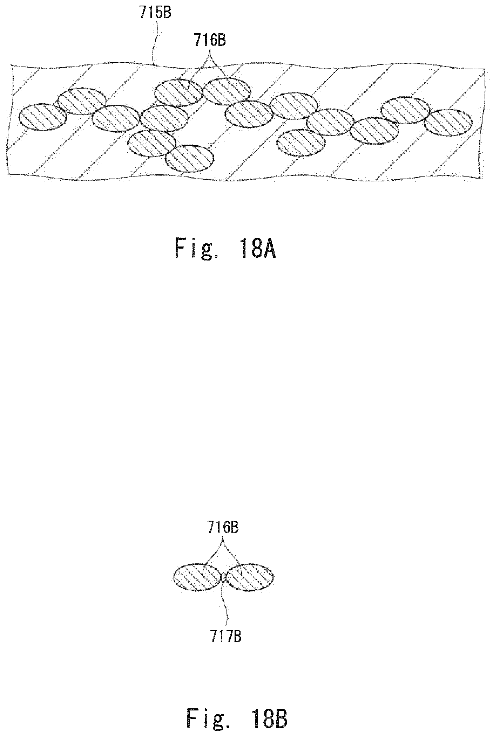

Instead of the heat transfer layers 710B, 711B, and 712B described above, a heat transfer layer 715B, as illustrated in Fig. 18A, may be provided.

As the binder of the heat transfer layer 715B, it is preferable to increase the heat conductivity between insulating fillers 716B. To increase the heat conductivity of the binder, it is desirable to have a high flexural modulus of the binder and to use an anisotropic polymer as the material. The flexural modulus is preferably between 0.5 GPa and 10 GPa.

Examples of polymers for binders with high flexural modulus include polyimides, epoxy resins and acrylic resins with bulky structures such as cycloolefin, tricyclodecane, and adamantyl skeletons, and anisotropic polymers such as liquid crystalline polymers or stretched polymers.

Examples of a binder for bonding the insulating fillers 716B together preferably include a functional group that can be chemically adsorbed (bonded) to the surface of the insulating fillers 716B dispersed in the heat transfer layer 715B, such as a carbonyl group, a hydroxyl group, an isocyanate group, a silanol group, a sulfo group, a group in which a hydrogen portion thereof is replaced by a metal ion, an amino group, and those having a structure in which the above functional groups are formed by hydrolysis or absorption of water.

The insulating fillers 716B are preferably insulating oxides or nitrides, or an element lighter than iron, from the viewpoint of enhancing transparency and heat transfer properties. Insulating oxides and nitrides include boron nitride, aluminum nitride, silicon nitride, magnesium oxide, aluminum oxide, and crystalline silica. They may also have a shell structure as a nucleus to enhance mixing performance and chemical bonding properties with the resin. The concentration of the insulating fillers 716B in the heat transfer layer 715B is preferably a concentration equal to or greater than the percolation concentration from the viewpoint of enhancing the heat transfer property. When the concentration is increased to a concentration equal to or greater than the percolation concentration, the insulating fillers 716B contact each other, and a network of the insulating fillers 716B is formed in the heat transfer layer 715B. As a result, heat is transferred to the surface direction of the display region A through the network of the insulating fillers 716B, and heat dissipation is promoted. Even if the insulating fillers 716B are not included at a concentration equal to or greater than the percolation concentration, heat dissipation is promoted compared to the case where the insulating fillers 716B are not included at all. The concentration of the insulating fillers 716B may be the same throughout the heat transfer layer 715B or may differ in one region. To differentiate the concentration of one region from that of other regions, it is preferable to make the concentration of the region located in the vicinity of the first partial region A1 higher than that of the region located in the vicinity of the second partial region A2 from the viewpoint of promoting heat dissipation of the first partial region A1.

It is also desirable to treat the insulating fillers 716B by modifying the filler surface, stretching the binder containing the filler, and applying an electric or magnetic field to align, orient, and bond the filler in the direction in which the heat is to be conducted since this makes it easier to increase the heat conductivity.

As the shape of the insulating fillers 716B, a shape having anisotropy is preferable from the viewpoint of securing a contact area with each other. The anisotropic shape includes a one-dimensional structure such as a fiber or wire shape or a two-dimensional structure such as a plate. It is preferred that the insulating fillers 716B be oriented in a specific direction, in particular, the long axis direction of the structure is oriented closer to the direction of heat conduction.

On the other hand, since insulating fillers 716B made of insulating oxides or the like is difficult to deform, it may be difficult to secure a contact area between the insulating fillers 716B. In this case, as illustrated in Fig. 18B, if expandable metal fillers 717B are sandwiched between the insulating fillers 716B, it will be easier to secure a contact area between the metal fillers 717B and the insulating fillers 716B. As a result, heat is easily transferred to the surface direction of the display region A through the network of the insulating fillers 716B and the metal fillers 717B.

From the viewpoint of suppressing coloration by suppressing surface deterioration of the metal fillers 717B, the material of the metal fillers 717B is preferably a metal having a small ionization tendency, that is, silver, aluminum, copper, and gold are preferable. From the viewpoint of transparency and insulating properties of the heat transfer layer 715B, the size of the metal fillers 717B is preferably smaller and, preferably 100 nm or less, more preferably 50 nm or less, and further preferably 10 nm or less.

From another viewpoint of ensuring the transparency of the heat transfer layer 715B, it is preferable that the difference between the refractive index of the binder and the refractive index of the insulating fillers 716B be small. From this point of view, among the binders, polymers having a structure containing a large amount of phenyl groups such as phenyl and fluorene, which have a high refractive index; polyimides; liquid crystalline polymers; phenyl polysiloxane; and nanocomposite polymers are preferred, and among these, phenylsilane-based polymers and fluorene-based polymers with high heat resistance are more preferable. On the other hand, examples of the insulating fillers 716B include fiber materials such as alumina and silica; and ellipsoidal particles such as titania as materials having a one-dimensional structure, and include hexagonal boron nitride, or zinc oxide as materials having a two-dimensional structure.

From yet another viewpoint of ensuring the transparency of the heat transfer layer 715B, the insulating fillers 716B is preferably smaller, specifically 100 nm or less is more preferable, and 50 nm or less is further preferable.

The number, shape, and position of the heat transfer layer are not limited to the above-described manner, and any manner may be used as long as the heat dissipation of the display region A can be promoted.

Although it is preferable for the heat transfer layer to be highly transparent, it need not be transparent in regions on non-transparent components such as the light-emitting units 20 and the IC chips 30. A non-transparent heat transfer layer provided on a non-transparent member such as the light-emitting units 20 or the IC chips 30 preferably has a heat conductivity higher than Si and is also preferably an insulating material. The non-transparent heat transfer layer may be formed by a colored, cloudy material. Nitrides, oxides, and the like are preferable when such materials are insulating materials. A non-transparent heat transfer layer may be provided only on the IC chips 30 and no transparent heat transfer layer may be provided in other regions. The non-transparent heat transfer layer may include an insulating filler with a concentration greater than or less than the percolation concentration. By providing a transparent or non-transparent heat transfer layer on the IC chips 30, destruction of the IC chips 30 due to thermal distortion can be suppressed.

In the configuration of Figs. 13 to 18A and 18B, the heat extraction unit 72A may not be provided.

The heat transfer layers 710B, 711B, 712B, 715B may be provided on both main surfaces of the first transparent substrate 10, in which case the same heat transfer layer may be provided on both main surfaces, or different heat transfer layers may be provided.

### <Third Embodiment>

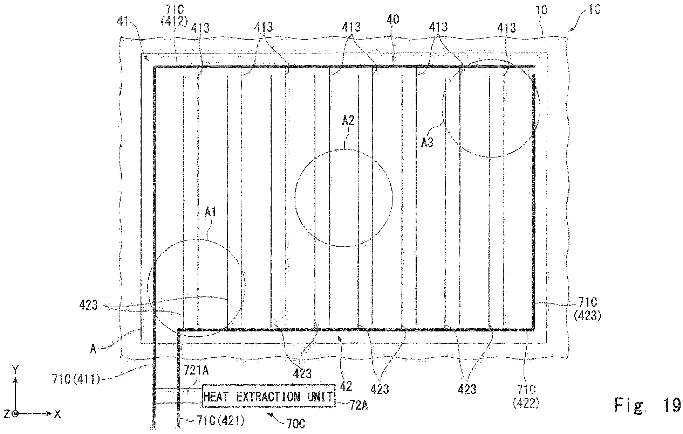

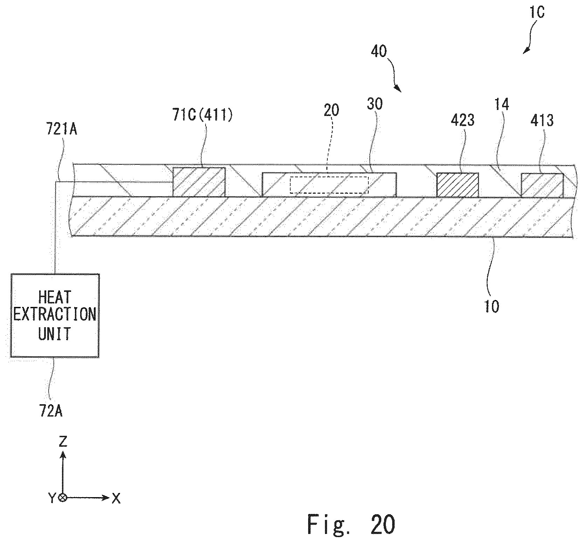

A transparent display device 1C of a third embodiment illustrated in Figs. 19 and 20 has a function of suppressing a temperature rise of the display region A. The difference between the transparent display device 1C of the third embodiment and the transparent display device 1A of the first embodiment is that a heat dissipation promotion unit 70C is provided instead of the heat dissipation promotion unit 70A.

The heat dissipation promotion unit 70C has a heat transfer wiring 71C and the heat extraction unit 72A.

The heat transfer wiring 71C includes portions of the power line 41 and the ground line 42, respectively. Of the lines which constitute the power line 41, the first power main line 411 and the second power main line 412 function as the heat transfer wiring 71C. Among the lines constituting the ground line 42, the first ground main line 421, the second ground main line 422, and the first ground branch line 423 (the rightmost first ground branch lines 423 in Fig. 19) extending from an end of the second ground main line 422 toward the second power main line 412 function as the heat transfer wiring 71C. The cross-sectional area of the heat transfer wiring 71C is larger than that of the lines that do not function as the heat transfer wiring 71C in the power line 41 and the ground line 42. Examples of the method of differentiating the cross-sectional area include differentiating at least one of the width and thickness. The width of the heat transfer wiring 71C is preferably between 1 µm and 1000 µm, more preferably between 2 µm and 500 µm, and further preferably between 3 µm and 200 µm. The thickness of 71C is preferably between 0.1 µm and 10 µm, more preferably between 0.2 µm and 8 µm, and further preferably between 0.5 µm and 5 µm. At least one of the width and thickness of at least one heat transfer wiring 71C may be different from other heat transfer wiring 71C.

The material of the heat transfer wiring 71C may be the same as or different from the lines that do not function as the heat transfer wiring 71C in the power line 41 and the ground line 42. Examples of the material of the heat transfer wiring 71C include copper, aluminum, silver, iron, or tungsten carbide.

The heat extraction unit 72A is connected to the first power main line 411 and the first ground main line 421, which function as the heat transfer wiring 71C, via the connection unit 721A.

According to the third embodiment described above, when the power line 41 and the ground line 42 generate heat due to the current flowing in the power line 41 and the ground line 42 in accordance with the image display, this heat flows from the narrower to the wider cross-sectional area in the heat transfer wiring 71C and is led to the heat extraction unit 72A. Accordingly, even when the power line 41 and the ground line 42, which are components other than the light-emitting units 20, generate heat, the heat dissipation of the display region A is promoted by the action of the heat extraction unit 72A, and the temperature rise of the display region A is suppressed.

### <Modification Example of Third Embodiment>

The following embodiment is a modification example of the third embodiment.

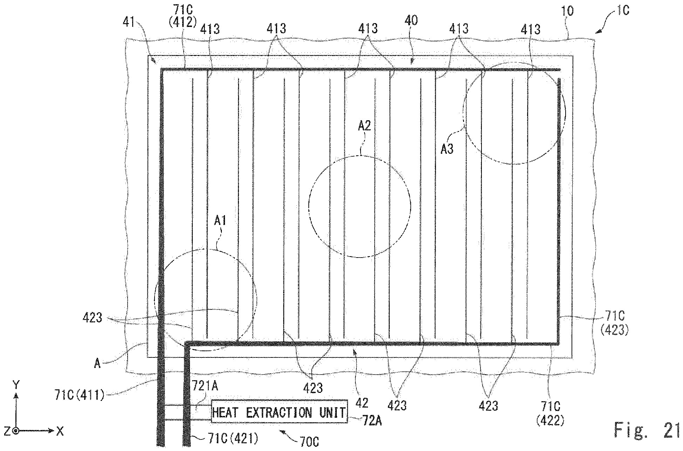

As illustrated in Fig. 19, the width of the heat transfer wiring 71C may be constant in the longitudinal direction or may become wider or narrower continuously or in stages as it approaches the heat extraction unit 72A. The thickness of the heat transfer wiring 71C may be constant in the longitudinal direction or may become thicker or thinner continuously or in stages as it approaches the heat extraction unit 72A. From the viewpoint of increasing the efficiency of heat transfer to the heat extraction unit 72A, it is preferable that the width of the heat transfer wiring 71C become wider as it approaches the heat extraction unit 72A and it is preferable that the thickness become thicker as it approaches the heat extraction unit 72A, as illustrated in Fig. 21. From the viewpoint of promoting heat dissipation in the first partial region A1, it is preferable that the width of the heat transfer wiring 71C become wider as it approaches the first partial region A1, and it is preferable that the thickness become thicker as it approaches the first partial region A1.

In the configuration of Figs. 19 to 21, only at least one or more but not more than four of the five pieces of the heat transfer wiring 71C may be provided. Among the lines constituting the power line 41 and the ground line 42, the lines that did not function as the heat transfer wiring 71C in the configurations of Figs. 19 to 21 may also function as the heat transfer wiring 71C. When the power line 41 or the ground line 42 has a line extending in the row direction, this line extending in the row direction may function as the heat transfer wiring 71C.

Only the power line 41 may function as the heat transfer wiring 71C, and only the ground line 42 may function as the heat transfer wiring 71C.

### <Fourth embodiment>

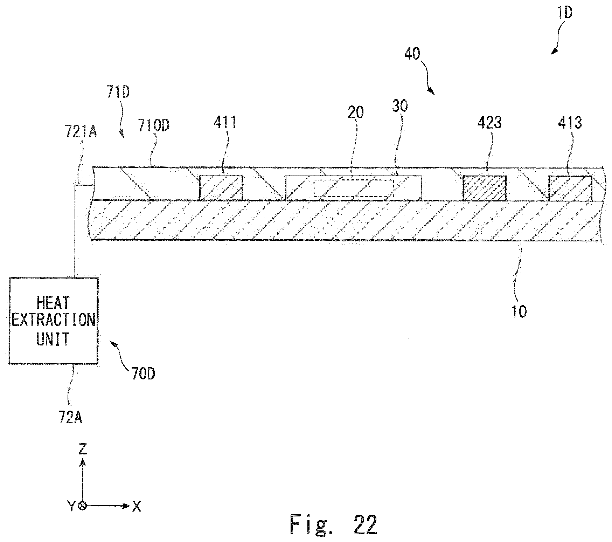

A transparent display device 1D of the fourth embodiment illustrated in Fig. 22 has a function of suppressing a temperature rise of the display region A. The difference between the transparent display device 1D of the fourth embodiment and the transparent display device 1A of the first embodiment is that a heat dissipation promotion unit 70D is provided instead of the heat dissipation promotion unit 70A.

The heat dissipation promotion unit 70D has a heat transfer unit 71D and the heat extraction unit 72A.

The heat transfer unit 71D has a heat-transfer and current-insulation layer 710D provided on the entire surface of the first transparent substrate 10 instead of the insulation layer 14. The heat-transfer and current-insulation layer 710D insulates the light-emitting units 20, the IC chips 30, and the wiring unit 40, and also has a function of suppressing the temperature rise. The material of the heat-transfer and current-insulation layer 710D includes aluminum nitride, aluminum oxide, silica, silicon carbide, silicon nitride, boron nitride, or dispersions of these materials. The thickness of the heat-transfer and current-insulation layer 710D may be the same throughout or may be different in one region. To differentiate the thickness of one region from that of other regions, from the viewpoint of promoting heat dissipation of the first partial region A1, it is preferable to make the thickness of the region located in the vicinity of the first partial region A1 thicker than that of the regions located in the vicinity of the second partial region A2.

The heat extraction unit 72A is connected to the heat-transfer and current-insulation layer 710D via the connection unit 721A.

According to the fourth embodiment described above, when the display region A generates heat due to the current flowing in the power line 41 and the ground line 42 in conjunction with image display, this heat is transferred to the surface direction of the display region A by the heat-transfer and current-insulation layer 710D, and the heat dissipation is promoted. Accordingly, even when a component other than the light-emitting units 20 generates heat, the temperature rise of the display region A is suppressed without making design changes to the light-emitting units 20, the IC chips 30, the wiring unit 40, and the like.

### <Modification Example of Fourth Embodiment>

The following embodiment is a modification example of the fourth embodiment.

Although the heat-transfer and current-insulation layer 710D is provided on the entire surface of the first transparent substrate 10, it may be provided to cover only the region on the first transparent substrate 10 where the amount of generated heat is large, and the insulation layer 14 may be provided in other regions. Examples of the regions that generate a large amount of heat include the power line 41 and the ground line 42, and the lines connecting the light-emitting units 20 and the IC chips 30.

Although it is preferable for the heat-transfer and current-insulation layer 710D to be highly transparent, it need not be transparent in regions on non-transparent components such as the light-emitting units 20 and the IC chips 30.

The heat extraction unit 72A may not be provided.

### <Fifth embodiment>

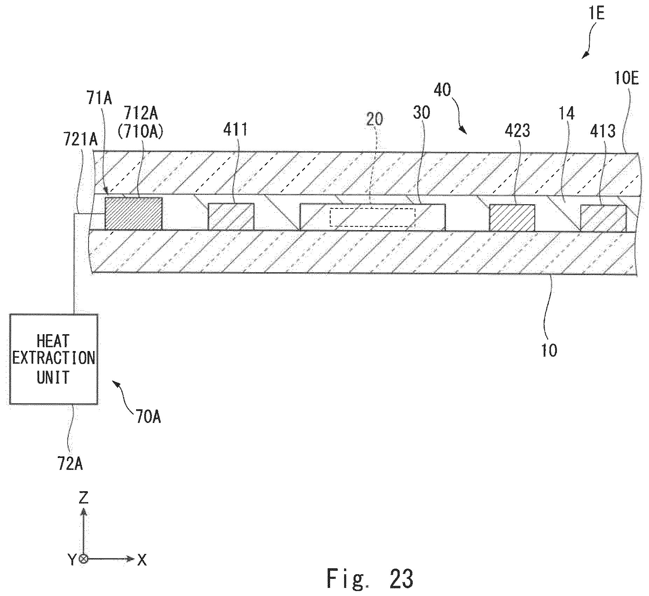

In the transparent display device 1A of the first embodiment, components such as the light-emitting units 20, the IC chips 30, the wiring unit 40, and the heat transfer unit 71A are arranged on the first transparent substrate 10. In contrast, a transparent display device 1E of the fifth embodiment illustrated in Fig. 23 sandwiches these components between the first transparent substrate 10 and a second transparent substrate 10E. This allows components such as the light-emitting units 20, the IC chips 30, the wiring unit 40, and the heat transfer unit 71A to be sealed and protected between the first and second transparent substrates 10, 10E.

The material, thickness, and the like of the second transparent substrate 10E are the same as those described above for the first transparent substrate 10. The first transparent substrate 10 and the second transparent substrate 10E may be the same or different with respect to the material, thickness, and the like.

### <Modification Example of Fifth Embodiment>

In the configurations of the transparent display devices 1B, 1C, and 1D of the second to fourth embodiments and the modification examples of the first to fourth embodiments, the components such as the light-emitting units 20 may be sandwiched between the first transparent substrate 10 and the second transparent substrate 10E.

### <Sixth Embodiment>

The transparent display devices 1A, 1B, 1C, 1D, 1E of the first to fifth embodiments and the configurations of the modification examples of the first to fifth embodiments can be used by attaching them to a glass plate, a vehicle, or the like by means of an attachment member such as an adhesive sheet. It can also be used as laminated glass with a transparent display device by sealing it between two glass plates. Such glass plates are preferably transparent.

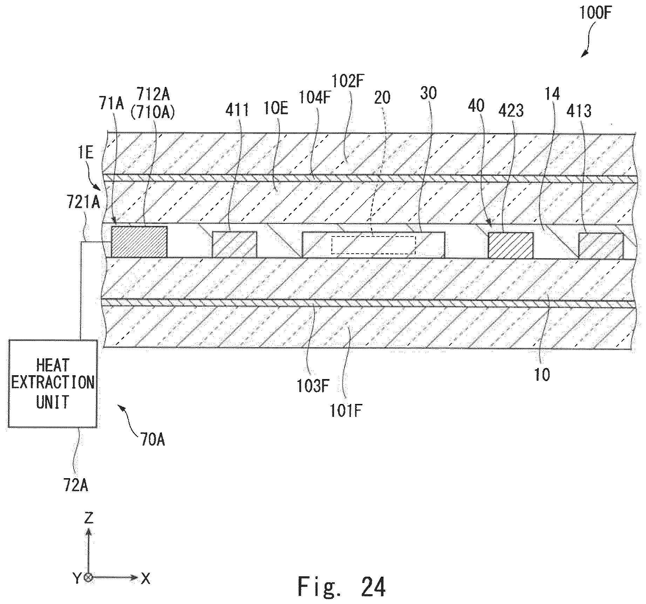

A laminated glass 100F with a transparent display device of the sixth embodiment illustrated in Fig. 24 has the transparent display device 1E of the fifth embodiment and a first glass plate 101F and a second glass plate 102F sandwiching the transparent display device 1E. The laminated glass 100F with a transparent display device can be manufactured by placing the transparent display device 1E on the first glass plate 101F, and then overlapping and bonding the second glass plate 102F.

Both inorganic glass and organic glass may be used for the first and second glass plates 101F, 102F. The inorganic glass includes, for example, soda-lime glass and the like. The inorganic glass may be either unreinforced glass or reinforced glass. Unreinforced glass is molten glass that has been formed into sheets and cooled slowly. Reinforced glass is made by forming a compressive stress layer on the surface of the unreinforced glass. The reinforced glass may be physically reinforced (e.g., tempered glass) or chemically reinforced glass. Organic glass, on the other hand, includes transparent resins such as polycarbonate and acrylic resin. At least one of the first and second glass plates 101F, 102F can be a laminated glass or a double-glazed glass obtained by using two or more pieces of glass. Both the first and second glass plates 101F, 102F preferably have a thickness between 0.5 mm and 5 mm, and more preferably a thickness between 1.5 mm and 2.5 mm. The material, composition, and thickness of the first and second glass plates 101F, 102F may be the same or different.

In manufacturing the laminated glass 100F with a transparent display device, a first adhesive layer 103F can be disposed between the transparent display device 1E and the first glass plate 101F, and a second adhesive layer 104F can be disposed between the transparent display device 1E and the second glass plate 102F. This allows the transparent display device 1E to be stabilized in the laminated glass 100F with a transparent display device. The materials of the first and second adhesive layers 103F, 104F are interlayers mainly made of cycloolefin copolymer (COP), vinyl acetate copolymer (EVA), polyvinyl butyral (PVB), and the like. The first and second adhesive layers 103F, 104F are provided on the entire surface or a part of the transparent display device 1E.

It is not necessary to provide at least one of the first and second adhesive layers 103F, 104F.

The laminated glass 100F with a transparent display device is not limited to a flat surface but may also have a curved surface. That is, the laminated glass 100F with a transparent display device may be curved. This curvature may be in one direction, or it may be curved in two directions, a first direction and a second direction orthogonal thereto.

To obtain the curved laminated glass 100F with a transparent display device, the transparent display device 1E is placed on the curved first glass plate 101F, and after overlapping the curved second glass plate 102F, or after further placing the first and second adhesive layers 103F, 104F at the positions illustrated in Fig. 24, the glass is heated and pressure treatment. As a result, the curved laminated glass 100F with a transparent display device can be obtained. If the second glass plate 102F is sufficiently thinner than the first glass plate 101F, the second glass plate 102F does not need to be pre-curved.

The laminated glass 100F with a transparent display device can be suitably used in applications where the viewing distance (the distance from the observer to the display screen) is, for example, between 0.25 m and 4.0 m. Specific applications include use in automotives as moving bodies, vehicles such as railroad cars, airplanes, buildings, transparent enclosures, and the like. More specifically, the laminated glass 100F with a transparent display device can be incorporated into at least part of window glass, such as a front window, a rear window, a side window, or the like in an automotive, or in window glass or posters in other transportation such as trains, windows such as a show window, a showcase, a display shelf with a door.

In this manner, even if the laminated glass 100F with a transparent display device is used in applications where the viewing distance is relatively close, the use of micro-sized LEDs and a predetermined percentage of low transmittance region as described above allows the transparency of the image on the rear side to be visible to be ensured while maintaining the display performance.

### <Seventh Embodiment>

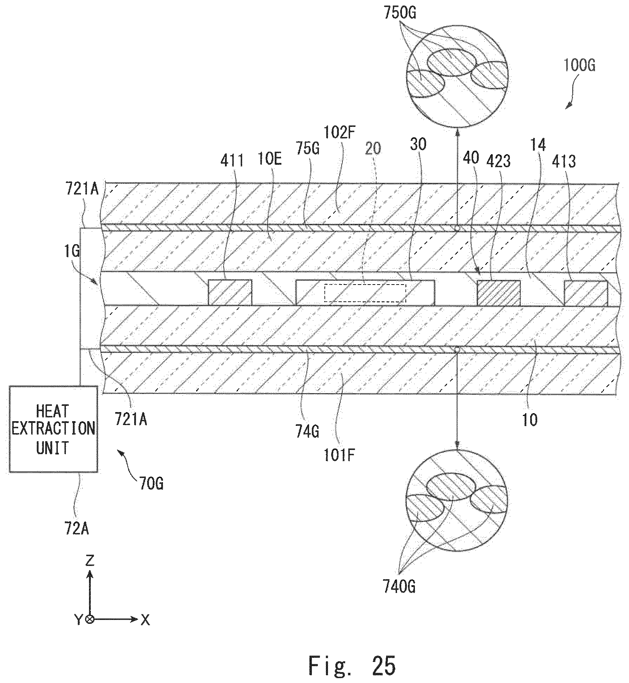

A laminated glass 100G with a transparent display device of the seventh embodiment illustrated in Fig. 25 includes a transparent display device 1G in which a first heat transfer adhesive layer 74G described below is provided on one surface of a first transparent substrate 10 of the transparent display device 1 of the related art, the second transparent substrate 10E sandwiching the light-emitting units 20 and other components of the transparent display device 1G with the first transparent substrate 10, the first glass plate 101F and the second glass plate 102F sandwiching the transparent display device 1G and the second transparent substrate 10E, and a heat dissipation promotion unit 70G.

The heat dissipation promotion unit 70G includes the first heat transfer adhesive layer 74G that bonds the first transparent substrate 10 to the first glass plate 101F, a second heat transfer adhesive layer 75G that bonds the second transparent substrate 10E to the second glass plate 102F, and the heat extraction unit 72A. The first and second heat transfer adhesive layers 74G, 75G are obtained by dispersing heat transferable fillers 740G, 750G as illustrated in a partially enlarged view in Fig. 25 when manufacturing the first and second adhesive layers 103F, 104F of the sixth embodiment. Examples of such heat transferable fillers 740G, 750G include metallic particles such as copper, aluminum, silver, iron, or tungsten carbide; carbon materials such as carbon, carbon nanotubes, graphite, graphene, carbide, or diamond; and insulating ceramic materials such as aluminum nitride, aluminum oxide, silica, and alumina silicate, glass fillers, silicon carbide, silicon nitride, boron nitride, or zinc oxide (ZnO). The concentrations of the fillers 740G and 750G in the first and second heat transfer adhesive layers 74G and 75G preferably have a concentration equal to or greater than the percolation concentration from the viewpoint of enhancing heat transfer by contacting each other. The shape of the fillers 740G, 750G is preferably an anisotropic shape such as a fiber shape or a wire shape from the viewpoint of securing a contact area with each other. The concentration of the fillers 740G, 750G may be the same throughout or may differ in one region. To differentiate the concentration of one region from that of other regions, it is preferable to make the concentration of the region located in the vicinity of the first partial region A1 higher than that of the region located in the vicinity of the second partial region A2 from the viewpoint of promoting heat dissipation of the first partial region A1.

If a carbon-based material other than diamond is used for the fillers 740G and 750G, it can be mixed with a metal or a material that ionizes when added to an electrolyte, as in the case with the heat transfer lines 710A.

The fillers 740G, 750G preferably have a refractive index difference from the resin material utilized in the first and second heat transfer adhesive layers 74G, 75G within 0.1, more preferably within 0.05, and further preferably within 0.01.

The total light transmittance of the first and second heat transfer adhesive layers 74G, 75G is preferably 40% or more, more preferably 50% or more, and further preferably 60% or more.

The heat extraction unit 72A is connected to the first and second heat transfer adhesive layers 74G, 75G via the connection unit 721A.

According to the seventh embodiment described above, heat dissipation of the display region A can be promoted without changing the design of the transparent display device 1 of the related art.

### <Modification Example of Seventh Embodiment>

The fillers 740G and the fillers 750G may be made of different materials.

For example, when the fillers 740G is made of an oxide, a metal filler having an extensible property may be sandwiched between the fillers 740G to secure a contact area between the fillers 740G and the metal fillers.

For example, as a filler to be dispersed in the first heat transfer adhesive layer 74G, a filler that maintains the shape of the first heat transfer adhesive layer 74G when the first heat transfer adhesive layer 74G is warmed by the heat of the display region A may be employed together with or instead of the heat transferable fillers 740G described above. Examples of such fillers that maintain the shape include silica, alumina, zirconia, or titania.

As the first heat transfer adhesive layer 74G or the second heat transfer adhesive layer 75G, an interlayer containing an ionomer as a main component, or an interlayer having a thermal cross-linking agent added to EVA with the above-described filler dispersed therein may be employed. In this configuration, the heat resistance of the first heat transfer adhesive layer 74G or the second heat transfer adhesive layer 75G can be improved.

Instead of the first heat transfer adhesive layer 74G or the second heat transfer adhesive layer 75G, an adhesive layer similar to the first adhesive layer 103F of the sixth embodiment, which does not include a heat transfer filler, may be used.

The first heat transfer adhesive layer 74G or the second heat transfer adhesive layer 75G need not be connected to the heat extraction unit 72A, and the heat extraction unit 72A need not be provided.

The laminated glass 100G with a transparent display device may be made into a curved shape as referred to in the sixth embodiment.

The transparent display devices 1A, 1B, 1C, 1D having the heat transfer units 71A, 71B, 71D of the first, second, and fourth embodiments, and the heat transfer wiring 71C of the third embodiment, and the first heat transfer adhesive layer 74G may be used to form a transparent display device similar to the transparent display device 1G.

A transparent display device similar to the transparent display device 1G above, the second transparent substrate 10E, the first and second glass plates 101F, 102F, and the second heat transfer adhesive layer 75G may be used to form a laminated glass with a transparent display device similar to the laminated glass 100G with a transparent display device.

### <Eighth Embodiment>

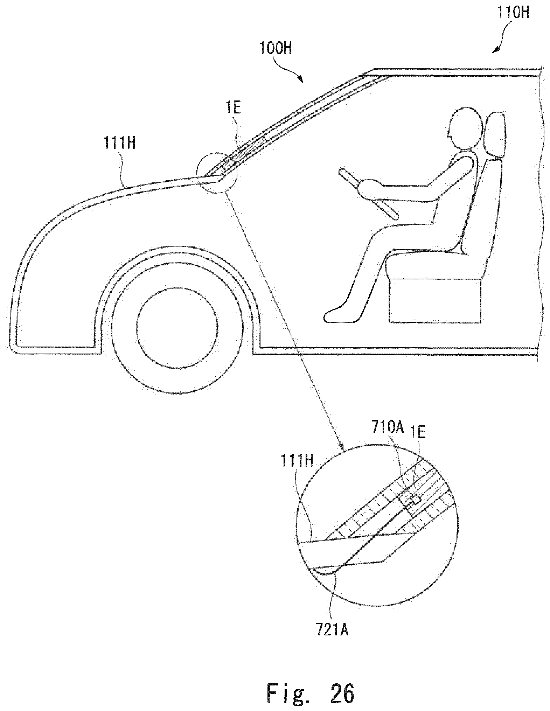

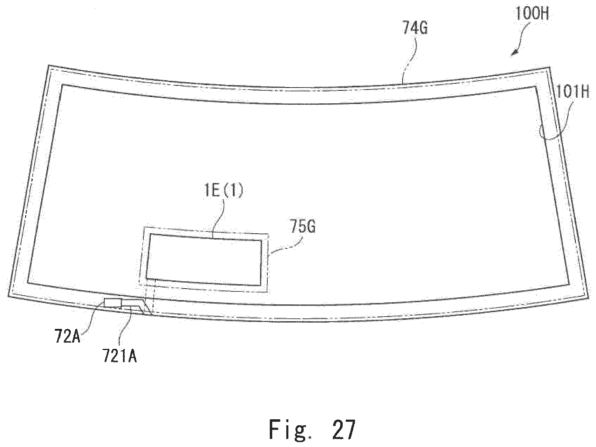

An automotive 110H as a vehicle of the eighth embodiment illustrated in Fig. 26 has a laminated glass with a curved laminated glass with a transparent display device as a windshield 100H. The components of the windshield 100H are the same as the laminated glass 100F with a transparent display device illustrated in Fig. 24. As illustrated in Fig. 27, the windshield 100H has a concealment layer 101H provided at the outer periphery of the windshield 100H. The concealment layer 101H is provided on the interior side of the car and has a function of hiding the interior of the car from the outside. The transparent display device 1E is manufactured to be smaller than the windshield 100H and is enclosed within a portion of the lower left side as viewed from the interior of the vehicle. The extent to which the transparent display device 1E is provided may be 50% or less, or even 30% or less of the surface area of the windshield 100H. The configuration other than the second transparent substrate 10E of the transparent display device 1E, the first glass plate 101F, and the first adhesive layer 103F constitute a glass plate with a transparent display device.

In such an automotive 110H, the heat extraction unit 72A connected to the heat transfer unit 71A of the transparent display device 1E is preferably disposed on the interior side of the car so as to be hidden by the concealment layer 101H. In this configuration, it is possible to suppress the degradation of the design of the automotive 110H due to the heat extraction unit 72A being visible from outside the car.

According to the eighth embodiment described above, the temperature rise of the display region A can be suppressed, and the degradation of the first and second adhesive layers 103F, 104F due to this temperature rise can be suppressed.

### <Modification Example of Eighth Embodiment>

The size of the transparent display device 1E may be approximately the same size as that of the windshield 100H.

Although the heat extraction unit 72A is arranged so as to be concealed by the concealment layer 101H, a body (main body part of the vehicle) 111 H to which the transparent display device 1E is assembled in the automotive 110H may be made to function as the heat extraction unit without the heat extraction unit 72A such as a heat-dissipating fin, and the body 111H and the heat transfer line 710A may be connected via the connection unit 721A as indicated by the double-dotted chain line in the partially enlarged view in Fig. 26. In this case, the configuration other than the second transparent substrate 10E of the transparent display device 1E, the first glass plate 101F, and the first adhesive layer 103F constitute a glass plate with a transparent display device.

The laminated glass 100F, 100G with a transparent display device of the fifth and seventh embodiments may be employed as the windshield 100H of the automotive 110H.

When the laminated glass 100G with a transparent display device of the seventh embodiment is employed as the windshield 100H of the automotive 110H, and the transparent display device 1 is enclosed within a part of the windshield 100H as illustrated in Fig. 27, both the first and second heat transfer adhesive layers 74G, 75G may have approximately the same size as the windshield 100H. Alternatively, as indicated by the double dotted line, for example, the first heat transfer adhesive layer 74G may have approximately the same size as the windshield 100H, and the second heat transfer adhesive layer 75G may be slightly larger than the transparent display device 1.

A member made of a single glass plate such as side glass of the automotive 110H may be provided with the transparent display device 1E to constitute a glass plate with a transparent display device. In this case, the body 111H, which functions as the heat extraction unit, and the heat transfer lines 710A may be connected via the connection unit 721A. If a concealment layer is provided on the glass plate, the heat extraction unit 72A may be disposed on the interior side of the vehicle so as to be concealed by the concealment layer.

### <Other Modification Examples>

The above-described first to eighth embodiments and modification examples may be combined as necessary to the extent possible.

This application claims priority based on Japanese Patent Application 2018-165127 filed on September 4, 2018 and Japanese Patent Application 2019-054427 filed on March 22, 2019, the entire disclosure of which is hereby incorporated herein.

### Reference Signs List

1, 1A, 1B, 1C, 1D, 1E, 1G transparent display device
10 first transparent substrate
10E second transparent substrate
11A through hole
20 light-emitting unit
30 IC chip
40 wiring unit
41 power line
42 ground line
70A, 70B, 70C, 70D, 70G heat dissipation promotion unit
71A, 71B, 71D heat transfer unit
71C heat transfer wiring
72A heat extraction unit
73A heat transfer material
74G first heat transfer adhesive layer
75G second heat transfer adhesive layer
100F, 100G laminated glass with transparent display device
101F first glass plate
101H concealment layer
102F second glass plate
110H automotive (vehicle)
111H body (main body part of vehicle)
710A, 716A, 717A heat transfer line
710B, 711B, 712B, 715B heat transfer layer
710D heat-transfer and current-insulation layer
715A insulation unit
716B insulating filler
740G, 750G filler
A display region

## Claims

1. A transparent display device comprising:
a first transparent substrate;
light-emitting units arranged on the first transparent substrate; and
a wiring unit connected to each of the light-emitting units, wherein
each of the light-emitting units includes a light-emitting diode having a surface area of 1 mm² or less, and
a display region includes a heat dissipation promotion unit configured to promote heat dissipation of the display region.

2. The transparent display device according to Claim 1, wherein
the light-emitting units each include the light-emitting diodes and are arranged for each pixel, and
the heat dissipation promotion unit has a higher heat dissipation capability in a region where an electric current flows in the wiring unit than in a region where the electric current flows less.

3. The transparent display device according to Claim 1 or 2, wherein the heat dissipation promotion unit includes a heat transfer unit that is structurally separate from the wiring unit.

4. The transparent display device according to Claim 3, wherein
the heat transfer unit includes a heat transfer line made of metal, and
an insulation unit is provided between the heat transfer line and the wiring unit.

5. The transparent display device according to Claim 4, wherein the heat transfer line is arranged to overlap with the wiring unit in plan view of the first transparent substrate.

6. The transparent display device according to any one of Claims 3 to 5, wherein the heat transfer unit includes a transparent heat transfer layer arranged to overlap with at least part of the display region in plan view of the first transparent substrate.

7. The transparent display device according to Claim 6, wherein the heat transfer layer includes a heat transfer filler.

8. The transparent display device according to Claim 7, wherein the heat transfer layer includes the heat transfer filler having a concentration equal to or greater than the percolation concentration.

9. The transparent display device according to any one of Claims 3 to 8, wherein the heat transfer unit is provided on at least one of a first main surface on the wiring unit side and a second main surface on a side opposite to the first main surface of the first transparent substrate.

10. The transparent display device according to any one of Claims 3 to 9, wherein
the first transparent substrate includes a through hole that penetrates in a thickness direction thereof, and
the through hole is filled with a heat transfer material that transfers heat of the display region to the heat transfer unit.

11. The transparent display device according to any one of Claims 3 to 10, wherein the heat transfer unit includes a heat-transfer and current-insulation layer that insulates the light-emitting units from the wiring unit.

12. The transparent display device according to any one of Claims 3 to 11, wherein the light-emitting units, the wiring unit, and the heat transfer unit are sandwiched between the first transparent substrate and a second transparent substrate.

13. The transparent display device according to any one of Claims 3 to 12, wherein the heat dissipation promotion unit includes a heat extraction unit that removes heat from the heat transfer unit.

14. The transparent display device according to Claim 1 or 2, wherein
the wiring unit includes a power line configured to carry a current to the light-emitting units and a ground line connected to the light-emitting units,
a cross-sectional area of one region on at least one of the power line and the ground line is larger than other regions on the at least one of the power line and the ground line, and
the heat dissipation promotion unit includes the one region and a heat extraction unit connected to the one region.

15. The transparent display device according to Claim 14, wherein the cross-sectional area of the one region of the at least one of the power line and the ground line increases as it approaches the heat extraction unit.

16. The transparent display device according to Claim 14 or 15, wherein the light-emitting units and the wiring unit are sandwiched between the first transparent substrate and a second transparent substrate.

17. The transparent display device according to any one of Claims 1 to 16, wherein
the first transparent substrate includes an adhesive layer on at least one side thereof,
the adhesive layer includes a heat transfer filler, and
the heat dissipation promotion unit includes the adhesive layer.

18. A glass plate with a transparent display device comprising the transparent display device according to any one of Claims 13 to 16, wherein
the first transparent substrate is disposed on a glass plate that is to be assembled to a main body part of a vehicle, and
the main body part functions as the heat extraction unit.

19. A glass plate with a transparent display device comprising the transparent display device according to any one of Claims 13 to 16, wherein
the first transparent substrate is disposed on a glass plate that is to be assembled to a main body part of a vehicle,
a concealment layer is provided on part of the glass plate, and
the heat extraction unit is disposed on an interior side of the main body part so as to be concealed by the concealment layer.

20. A laminated glass with a transparent display device comprising:
the transparent display device according to any one of Claims 1 to 17;
a glass plate on which the first transparent substrate is disposed; and
another glass plate sandwiching the transparent display device with the glass plate.

21. A vehicle comprising the transparent display device according to any one of Claims 1 to 17.
